# EUROPEAN PATENT APPLICATION

(11) **EP 4 199 032 A1**
(43) Date of publication of application: **21.06.2023**
(21) Application number: 21215710.1
(22) Date of filing: 17.12.2021
(51) Int. Cl.: H01J 37/244, H04N 5/32, H04N 5/367

(54) **DETECTOR INSPECTION DEVICE, DETECTOR ASSEMBLY, DETECTOR ARRAY, APPARATUS, AND METHOD**

(71) Applicant: ASML Netherlands B.V., 5500 AH Veldhoven (NL)
(72) Inventor: WIELAND, Marco, Jan-Jaco, 5500 AH Veldhoven (NL); STEENSTRA, Herre, Tjerk, 5500 AH Veldhoven (NL); LOOIJE, Alexius, Otto, 5500 AH Veldhoven (NL); VAN LEEUWEN, Richard, Michel, 5500 AH Veldhoven (NL); VISSER, Erwin, Robert, Alexander, 5500 AH Veldhoven (NL); RODRIGUES MANSANO, Andre, Luis, 5500 AH Veldhoven (NL); VAN T VEEN, Gretchen, Renée, 5500 AH Veldhoven (NL); SEEKLES, Duije, 5500 AH Veldhoven (NL); MARISSEN, Roelof, Albert, 5500 AH Veldhoven (NL)
(74) Representative: ASML Netherlands B.V.

(57) **Abstract**

The present invention provides a detector inspection device for interrogating at least part of a detector comprised in a charged particle-optical assessment apparatus, the detector inspection device comprising: a coupler configured to be positioned proximate to a detector element of a detector; and a device controller configured to apply a stimulating signal to the coupler to stimulate a response signal in the detector for interrogating at least part of the detector.

## Description

### FIELD

The embodiments provided herein generally relate to a detector inspection device, a detector assembly, a detector array, an apparatus, and a method.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal particles, e.g. electrons, to be emitted from the surface, such as secondary electrons, backscattered electrons or Auger electrons. The generated signal particles may be emitted from the material structure of the sample. By scanning the primary electron beam as the probing spot over the sample surface, signal particles can be emitted across the surface of the sample. By collecting these emitted signal particles from the sample surface, a pattern inspection tool may obtain data representing characteristics of the material structure of the surface of the sample. The data may be referred to as an image and may be rendered into an image.

The emitted signal particles can generally be detected by a detector which is part of the pattern inspection tool. Such a detector needs to be able to detect charged particles with very small currents to a high degree of accuracy. It is beneficial to check the detector to ensure that it is functioning as intended. However, it can be difficult to check the detector without affecting characteristics of the detector and/or without a complex setup.

### SUMMARY

It is an object of the present disclosure to provide ways of interrogating at least part of a detector.

According to an aspect of the invention, there is provided a detector inspection device for interrogating at least part of a detector comprised in a charged particle-optical assessment apparatus, the detector inspection device comprising: a coupler configured to be positioned proximate to a detector element of a detector; and a device controller configured to apply a stimulating signal to the coupler to stimulate a response signal in the detector for interrogating at least part of the detector.

According to an aspect of the invention, there is provided a detector assembly for an assessment apparatus for projecting a charged particle beam towards a sample, the assembly comprising: a detector comprising a detector element configured to detect signals from a sample and a shield electrode positioned proximate to the detector element; and a detector controller configured to apply a stimulating signal to at least part of the shield electrode to stimulate a response signal in the detector for interrogating at least part of the detector.

According to an aspect of the invention, there is provided a detector assembly for a multi-beam assessment apparatus for projecting a charged particle beam towards a sample, the assembly comprising: a detector comprising: a detector element comprising a semiconductor type element and/or a converter type element; and a verification element associated with the detector element; and a detector controller configured to apply a stimulating signal to at least part of the shield electrode to stimulate a response signal in the detector for interrogating at least part of the detector.

According to an aspect of the invention, there is provided a detector array comprising at least one detector assembly as described herein.

According to an aspect of the invention, there is provided assessment apparatus for assessing a sample, desirably for projecting charged particles towards a sample desirably in an array of beams, the assessment apparatus comprising: a sample support for supporting a sample; a detector assembly comprising a detector configured to detect signals from a sample supported by the sample support; and a detector controller configured to control and be in communication with the detector; and the detector inspection device described herein, wherein the device controller of the detector inspection device is configured to be in signal communication with the detector controller.

According to an aspect of the invention, there is provided a method of interrogating at least part of a detector for a charged particle-optical assessment apparatus, the method comprising: generating a stimulating signal in a coupler; stimulating a response signal in the detector element in response to the stimulating signal; and detecting the response signal in the detector element.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1****.**
**FIG. 3** is a schematic diagram of an exemplary multi-beam apparatus according to an embodiment.
**FIG. 4** is a bottom view of the portion of a detector assembly in **FIG. 3**
**FIG. 5A** and **FIG. 5B** show a bottom view of variations of a detector.
**FIG. 6A and 6B** are schematic representations of a detector array and an associated cell array according an embodiment, a schematic representation of a cell of the cell array, and a cell of the cell array according to an embodiment.
**FIG. 7** is a schematic representation of a cross-section wiring route showing circuit wires and a shielding arrangement according to an embodiment.
**FIG. 8** is a schematic cross-sectional view of a detector inspection device and part of a detector assembly according to an embodiment.
**FIG. 9** is a schematic cross-sectional view of a detector assembly and a detector inspection device according to an embodiment.
**FIG. 10** is a cross-section of a detector assembly according to an embodiment.
**FIG. 11** is a cross-section of a detector assembly according to an embodiment.

The figures are schematic. The schematic diagrams and views show the components described below. However, the components depicted in the figures are not to scale. Relative dimensions of components in drawings are exaggerated for clarity. Within the following description of drawings the same or like reference numbers refer to the same or like components or entities, and only the differences with respect to the individual embodiments are described.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of devices, assemblies, arrays, apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one defect can cause device failure. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate signal particles, e.g. secondary electrons and/or back-scatter electrons. The detection apparatus captures the signal particles from the sample as the sample is scanned so that the SEM can create an image of the scanned area of the sample. For high throughput inspection, some of the inspection apparatuses use multiple focused primary beams, i.e. a multi-beam, of primary electrons. The component beams of the multi-beam may be referred to as sub-beams or beamlets or an array of primary beams. A multi-beam can scan different parts of a sample simultaneously. A multi-beam inspection (or assessment) apparatus can therefore inspect a sample at a much higher speed than a single-beam inspection (or assessment) apparatus. An implementation of a known multi-beam inspection system is described below.

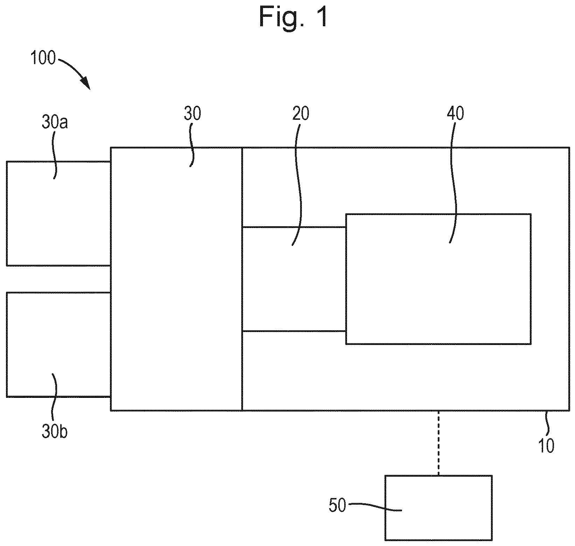

Reference is now made to **FIG. 1****,** which is a schematic diagram illustrating an exemplary charged particle beam assessment system 100. The charged particle beam assessment system100 of **FIG. 1** includes a main chamber 10, a load lock chamber 20, an charged particle beam apparatus 40 (which may otherwise be referred to as an electron beam apparatus), an equipment front end module (EFEM) 30 and a controller 50. The charged particle beam apparatus 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. After reaching the first pressure below the atmospheric pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second lower pressure. After reaching the second pressure, the sample is transported to the charged particle beam apparatus 40 by which it may be inspected. Depending on the configuration used, the second pressure may be deeper than between 10⁻⁷ to 10⁻⁵ mbar. An charged particle beam tool 40 may comprise a multi-beam charged particle -optical apparatus.

The controller 50 is electronically connected to the charged particle beam tool 40. The controller 50 may be a processor (such as a computer) configured to control the charged particle beam inspection apparatus 100. The controller 50 may include a processing circuitry configured to execute various signal and image processing functions. While the controller 50 is shown in FIG. 1 as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing a charged particle beam inspection tool, it should be noted that aspects of the disclosure in their broadest sense are not limited to a chamber housing an charged particle beam inspection tool. Rather, it is appreciated that the foregoing principles may also be applied to other tools and other arrangements of apparatus, that operate under the second pressure.

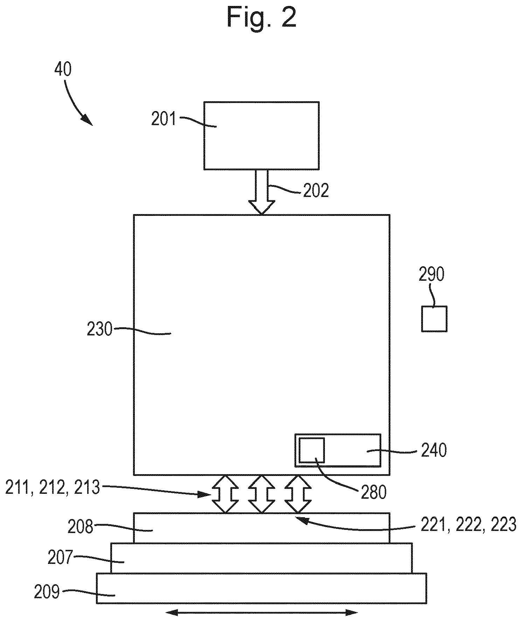

Reference is now made to **FIG. 2****,** which is a schematic diagram illustrating an exemplary charged particle beam tool 40 including a multi-beam inspection tool that is part of the exemplary charged particle beam inspection apparatus 100 of **FIG. 1****.** The multi-beam charged particle beam tool 40 (also referred to herein as apparatus 40) comprises an charged particle source 201, a projection apparatus 230, a motorized stage 209, and a sample holder 207. The charged particle source 201 and projection apparatus 230 may together be referred to as an illumination apparatus. The sample holder 207 is supported by motorized stage 209 so as to hold a sample 208 (e.g., a substrate or a mask) for inspection. The multi-beam charged particle beam tool 40 further comprises a detector array 240 (e.g. an electron detection device).

The controller 50 may be connected to various parts of the charged particle beam inspection apparatus 100 of **FIG. 1****.** The controller 50 may be connected to various parts of the charged particle beam tool 40 of **FIG. 2****,** such as the charged particle source 201, the detector array 240, the projection apparatus 230, and the motorized stage 209. The controller 50 may perform various data, image and/or signal processing functions. The controller 50 may also generate various control signals to govern operations of the charged particle beam inspection apparatus 100, including the charged particle multi-beam apparatus. The controller 50 may control the motorized stage 209 to move sample 208 during inspection of the sample 208. The controller 50 may enable the motorized stage 209 to move the sample 208 in a direction, for example continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

The charged particle source 201 may comprise a cathode (not shown) and an extractor or anode (not shown). During operation, the charged particle source 201 is configured to emit charged particle (e.g. electrons) as primary charged particles from the cathode. The primary charged particles are extracted or accelerated by the extractor and/or the anode to form a primary charged particle beam 202. The charged particle source 201 may comprise multiple sources, such as described in EP20184161.6, which is hereby incorporated by reference at least with respect to the multiple sources and how they relate to multiple columns and their associated charged particle-optics.

The projection apparatus 230 is configured to convert the primary charged particle beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets. Furthermore, although the present description and figures relate to a multi-beam system, a single beam system may be used instead in which the primary charged particle beam 202 is not converted into multiple sub-beams. The sub-beams may be generally interchangeable with a single primary charged particle beam 202. For example, a single beam system could be used as described in US 2021/0319977.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, signal charged particles (e.g. electrons) are generated (i.e. emitted) from the sample 208 which include secondary signal particles and backscatter signal particles. The signal particles emitted from the sample, e.g. secondary electrons and backscatter electrons, may otherwise be referred to as charged particles, e.g. secondary charged particles and backscatter charged particles. Signal beams are formed of signal particles emitted from the sample. It will generally be understood that any signal beams emitted from the sample 208 will travel in a direction with at least a component substantially opposite to the charged particle beams (i.e. the primary beams), or will have at least a component of direction which is opposite to the direction of the primary beams. Signal particles, which are emitted by the sample 208 may also pass through the electrodes of the objective lens and would also be affected by the field.

The detector array 240 is configured to detect (i.e. capture) signal particles emitted from the sample 208. The detector array 240 is configured to generate corresponding signals which are sent to a signal processing system 280, e.g. to construct images of the corresponding scanned areas of sample 208. The detector array 240 may be incorporated into the projection apparatus 230. The detector array may otherwise be referred to as a sensor array, and the terms "detector" and "sensor" and "sensor unit" are used interchangeably throughout the application.

The signal processing system 280 may comprise a circuit (not shown) configured to process signals from the detector array 240 so as to form an image. The signal processing system 280 could otherwise be referred to as an image processing system or a data processing system. The signal processing system may be incorporated into a component of the multi-beam charged particle beam tool 40 such as the detector array 240 (as shown in **FIG. 2**). However, the signal processing system 280 may be incorporated into any components of the inspection apparatus 100 or multi-beam charged particle beam tool 40, such as, as part of the projection apparatus 230 or the controller 50. The signal processing system 280 could be located outside of the structure that includes the main chamber which is shown in **FIG. 1****.** The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector array 240 permitting signal communication, such as an electrical conductor, optical fiber cable, portable storage media, IR, Bluetooth, internet, wireless network, wireless radio, among others, or a combination thereof. The image acquirer may receive a signal from the detector array 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary signal particles. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

Known multi-beam systems, such as the charged particle beam tool 40 and charged particle beam inspection apparatus 100 described above, are disclosed in US2020118784, US20200203116, US 2019/0259570 and US2019/0259564 which are hereby incorporated by reference.

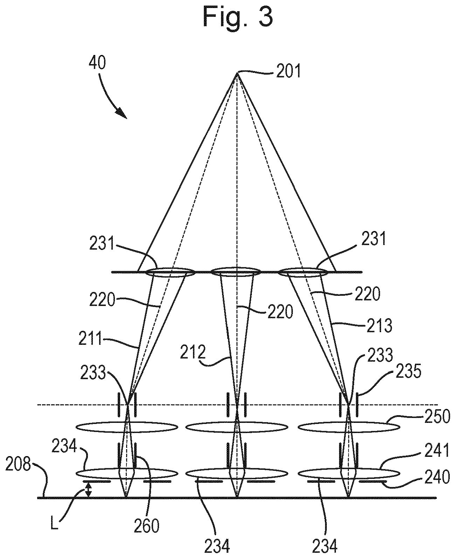

Components of an assessment device 40 (of for example an assessment apparatus 100) which may be used in the present invention are described below in relation to **FIG. 3** which is a schematic diagram of an assessment tool 40. The charged particle assessment tool 40 of **FIG. 3** may correspond to the multi-beam charged particle beam tool (also referred to herein as apparatus 40).

The charged particle source 201 directs charged particles (e.g. electrons) toward an array of condenser lenses 231 (otherwise referred to as a condenser lens array) forming part of the projection system 230. The charged particle source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. which is herein incorporated by reference at least so far as the features of an objective lens array disclosed therein. There may be some variation for optimizing aberration corrections as described in EP Application 20207178.3 filed on 12 November 2020, for example in figure 12, which is herein incorporated by reference at least with respect to corrections achieved by varying aperture diameter.

Voltage sources (which may be provided by individual electric power sources, or may all be supplied by electric power source 290) may be used to apply potentials to at least one electrode of the objective lens array 241, at least one electrode of the control lens 250 and/or to the sample to control projection of the primary beam(s) through the objective lens array 241, as described in EP Application 20207178.3 filed on 12 November 2020, for example in figure 14, and in EP 21174518.7 filed 18 May 2021. Variation in the potentials can be used for different landing energies, to control the beam opening angle and/or the focus of the primary beam on the sample. The potentials may be controlled to accelerate or decelerate the primary beam through the objective lens array 241 towards the sample.

The detector array 240 (which may otherwise be referred to as an array of detectors) comprises a plurality of detectors. Each detector is associated with a corresponding sub-beam (which may otherwise be referred to as a beam or primary beam). In other words, the arrays of detectors (i.e. the detector array 240) and sub-beams correspond. Each detector may be assigned to a sub-beam.

The array of detectors may correspond with the array of objective lenses. In other words, the array of detectors may be associated with the corresponding array of objective lenses. A detector array 240 is described below. However, any reference to detector array 240 could be replaced with a single detector (i.e. at least one detector) or multiple detectors as appropriate. The detectors may otherwise be referred to as of detector elements 405 (e.g. sensor elements such as capture electrodes). The detectors may be any appropriate type of detector.

The detector array 240 may be positioned at a position along the primary beam path at any location between an upper beam position and a lower beam position along the beam path. The upper beam position is above the objective lens array and optionally any associated lens arrays such as a control lens array (i.e. up beam of an objective lens array assembly). The lower beam position is down beam of the objective lens array. In an arrangement the detector array may be an array that is up beam of the objective lens array assembly. The detector array may be associated with any electrode of the objective lens array assembly. Reference hereafter of a detector in association with an electrode of the objective lens array may correspond to an electrode of the objective lens array assembly, except for the most down beam surface of the most down beam electrode of the objective lens array, unless stated explicitly otherwise.

In an arrangement the detector array 240 may be positioned between the control lens array 250 and the sample 208. The detector array 240 may be positioned between the objective lenses 234 and the sample 208, as shown in **FIG. 3**. Although this may be desirable, the detector array 240 could be provided in additional or alternative locations. Multiple detector arrays may be provided in a variety of locations.

The detector array 240 may be positioned proximate and/or adjacent the sample. The detector being proximate and/or adjacent the sample enables the risk of cross-talk in detection of signal particles generated by sub-beams which correspond to another detector in the detector array to be reduced if not avoided.

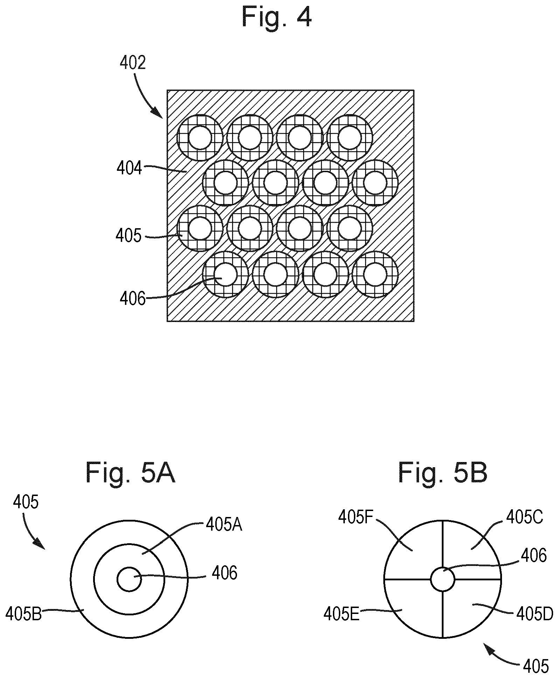

**FIG. 4** is a bottom view (i.e. a plan view) of detector array 240 which comprises a substrate 404 on which are provided a plurality of detector electrodes 405 each surrounding a beam aperture 406. The beam apertures 406 may be formed by etching through substrate 404. In the arrangement shown in **FIG.** 4, the beam apertures 406 are shown in a hexagonal close packed array. The beam apertures 406 can also be differently arranged, e.g. in a rectangular array. The detector electrodes 405 are isolated from each other by a gap between the detector electrodes 405. Furthermore, the substrate 404 isolates the detector elements 405 from each other, and could otherwise be referred to as an isolating element.

The detector array 240 may be within a certain distance of the sample 208, e.g. close to the sample. The at least one detector may be positioned in the device so as to face the sample. Thus, the at least one detector may be configured to face towards a sample support configured to support the sample 208, e.g. the sample holder 207. That is the detector may provide a base to the device. The detector as part of the base may face a surface of the sample. -For example, the at least one detector array may be provided on an output side of the objective lens array 241. The output side of the objective lens array 241 is the side on which the sub-beams are output from the objective lens array 241, i.e. the bottom or downbeam side of the objective lens array in the configuration shown in **FIG. 3****.** In other words, the detector array 240 may be provided downbeam of the objective lens array 241. The detector array 241 may be an integral component of the objective lens array 241. The detector and objective lens may be part of the same structure. The detector may be connected to the lens by an isolating element or directly to an electrode of the objective lens. Thus, the at least one detector may be part of an objective lens assembly comprising at least the objective lens array and the detector array. If the detector array is an integral component of the objective lens array 241, the detector array 240 may be provided at the base of the objective lens array 241. In an arrangement the detector array 240 may be integral to the most-down-beam positioned electrode of the objective lens array 241.

Desirably, a distance 'L' as shown in **FIG. 3**, between the detector array 240 and the sample 208 is between approximately 20 to 100 µm, i.e. the detector array 240 is positioned within approximately 20 to 100 micron for example from the sample 208. Generally the distance L is small so to ensure detector efficiency and/or reduce cross-talk, for example between 5 and 200 micron. The distance L is determined as the distance from a surface of the sample 208 facing the detector array 240 and a surface of the detector array 241 facing the sample 208.

In an embodiment, the objective lens array 241 is an exchangeable module, either on its own or in combination with other elements such as the control lens array and/or detector array. The exchangeable module may be field replaceable, i.e. the module can be swapped for a new module by a field engineer. In an embodiment, multiple exchangeable modules are contained within the tool and can be swapped between operable and non-operable positions without opening the tool.

In some embodiments, one or more aberration correctors are provided that reduce one or more aberrations in the sub-beams. The one or more aberration correctors may be provided in any of the embodiments, e.g. as part of the charged particle-optical device, and/or as part of an optical lens array assembly, and/or as part of an assessment tool. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. up beam or down beam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different sub-beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. The condenser lenses and correctors may be part of the same structure. For example they may be connected to each other, for example with an electrically isolating element. The aberration correctors may be CMOS based individual programmable deflectors as disclosed in EP2702595A1 or an array of multipole deflectors as disclosed EP2715768A2, of which the descriptions of the sub-beam manipulators in both documents are hereby incorporated by reference.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. Additionally or alternatively, one or more scanning deflectors (not shown) may be integrated with, or directly adjacent to, one or more of the objective lenses 234 for scanning the sub-beams 211, 212, 213 over the sample 208. In an embodiment, the scanning deflectors described in US 2010/0276606, which document is hereby incorporated by reference in its entirety, may be used.

In an embodiment, a single detector element 405 surrounds each beam aperture 406. In another embodiment, a plurality of detector elements 405 are provided around each beam aperture 406. Thus, the detector comprises multiple portions, and more specifically, multiple detecting portions. The plurality of detector portions may, together, have a circular perimeter and/or a diameter. The plurality of detector portions may, together, have an area extending between the aperture and the perimeter of the plurality of detector portions. The different portions may be referred to as different zones. Thus the detector may be described to have multiple zones or detection zones. Such a detector may be referred to as a zoned detector. The signal particles captured by the detector elements 405 surrounding one beam aperture 406 may be combined into a single signal or used to generate independent signals. The surfaces of the detector elements, optionally their detector portions, may substantially fill the surface of the substrate supporting the detector elements. The detector comprising multiple portions may be provided in any of the detector arrays described herein.

The zoned detector may be associated with one of the sub-beams 211, 212, 213. Thus, the multiple portions of one detector may be configured to detect signal particles emitted from the sample 208 in relation to one of the sub-beams 211, 212, 213. The detector comprising multiple portions may be associated with one of the apertures in at least one of the electrodes of the objective lens assembly. More specifically, the detector 405 comprising multiple portions may be arranged around a single aperture 406 as shown in **FIG 5A** and **FIG 5B**, which provide examples of such a detector.

The portions of the zoned detector may be separated in a variety of different ways, e.g. radially, annular, or any other appropriate way. Desirably the portions are of similar angular size and/or similar area and/or similar shape, for example as shown in **FIG 5B**. The separated portions may be provided as a plurality of segments, a plurality of annular portions (e.g. a plurality of concentric annuli or rings), and/or a plurality of sector portions (i.e. radial portions or sectors). The detector elements 405 may be divided radially. For example, the at least one detector 405 may be provided as annular portions comprising 2, 3, 4, or more portions. More specifically, as shown in **FIG. 5A****,** the detector 405 may comprise an inner annular portion 405A surrounding aperture 406 and an outer annular portion 405B, radially outwards of the inner annular portion 405A. Alternatively, the detector elements 405 may be divided angularly. For example, the detector may be provided as sector portions comprising 2, 3, 4, or more portions, for example 8, 12 etc.. If the detector is provided as two sectors, each sector portion may be a semi-circle. If the detector is provided as four sectors, each sector portion may be a quadrant. This is shown in **FIG. 5B** in which the 405 is divided into quadrants, i.e. four sector portions is shown in **FIG. 5B****,** as described below. Alternatively, the detector may be provided with at least one segment portion. The electrode elements may be separated both radially and angularly (e.g. in a dart board arrangement) or in any other convenient manner.

Each portion may have a separate signal read-out. The detector being separated into portions, e.g. annular portions or sector portions, is beneficial in that it allows more information to be obtained in relation to the signal particles detected. Thus, providing the detector 405 with multiple portions may be beneficial in obtaining additional information relating to the detected signal particles. This can be used to improve the signal to noise ratio of the detected signal particles. However, there is an additional cost in terms of the complexity of the detector.

As shown in **FIG. 5A**, the detector, in which an aperture 406 is defined and configured for the through passage of a charged particle beam, comprises inner detecting portion 405A and outer detecting portion 405B. The inner detecting portion 405A surrounds the aperture 406 of the detector. The outer detecting portion 405B is radially outwards of the inner detecting portion 405A. The shape of the detector may be generally circular. Thus, the inner detecting portion and the outer detecting portion may be concentric rings. In an example, the detector may be divided into two (or more) concentric rings, for example, as depicted in **FIG 5A****.**

Providing multiple portions concentrically or otherwise may be beneficial because different portions of the detector may be used to detect different signal particles, which may be smaller angle signal particles and/or larger angle signal particles, or secondary signal particles and/or backscatter signal particles. Such a configuration of different signal particles may suit a concentrically zoned detector. The different angled backscatter signal particles may be beneficial in providing different information. For example, for signal particles emitted from a deep hole, small-angle backscatter signal particles are likely to come more from the hole bottom, and large-angle backscatter signal particles are likely to come more from the surface and material around the hole. In an alternative example, small-angle backscatter signal particles are likely to come more from deeper buried features, and large-angle backscatter signal particles are likely to come more from the sample surface or material above buried features.

Any appropriate variation in the apparatus may be implemented. For example, the macro-collimator may be partially or wholly replaced by a collimator element array provided down-beam of the upper beam limiter. For example, a macro scan deflector 265 may be provided to cause sub-beams to be scanned over the sample 208. For example, the macro scan deflector 265 may be partially or wholly replaced by a scan deflector array.

In other embodiments both a macro scan deflector 265 and the scan-deflector array are provided. In such an arrangement, the scanning of the sub-beams over the sample surface may be achieved by controlling the macro scan deflector and the scan-deflector array 260 together, desirably in synchronization.

The invention can be applied to various different tool architectures. For example, the charged particle beam tool 40 may be a single beam tool, or may comprise a plurality of single beam columns or may comprise a plurality of columns of multi-beams (i.e. sub-beams). The columns may comprise the charged particle optical device described in any of the above embodiments or aspects. As a plurality of columns (or a multi-column tool), the devices may be arranged in an array which may number two to one hundred columns or more. The charged particle optical device may be a charged particle optical column. A charged particle column may optionally comprise a source.

If multiple detector arrays are provided, they may be configured to detect signal particles simultaneously. The detectors may be positioned to face up-beam of the primary beam paths 320. In other words, the detectors may be configured to face along the primary beam path 320 towards a source of the primary beam (described above as source 201), i.e. away from the sample 208. The detectors may be configured to face towards the sample, i.e. in the direction of the sample 208. In other words, the detectors may be facing in a direction along the primary beam path 320 towards the sample 208, i.e. away from the source.

Any of the detector arrays may be associated with (e.g. in, on, positioned adjacent to, connected to, or integrated with) at least one electrode of the objective lens array 241 (e.g. either the upper electrode 242 or the lower electrode 243). For example, the array of detectors may be in or on at least one electrode of the objective lens array 241. For example, the array of detectors may be positioned adjacent to one of the electrodes. In other words, the array of detectors may be positioned in close proximity and next to one of the electrodes. For example, the array of detectors may be connected (e.g. mechanically connected) to one of the electrodes. In other words, the array of detectors may be attached to one of the electrodes, e.g. by adhesive or welding or some other attachment method. For example, the array of detectors may be integrated with the one of the electrodes. In other words, the array of mirror detectors may be formed as part of one of the electrodes.

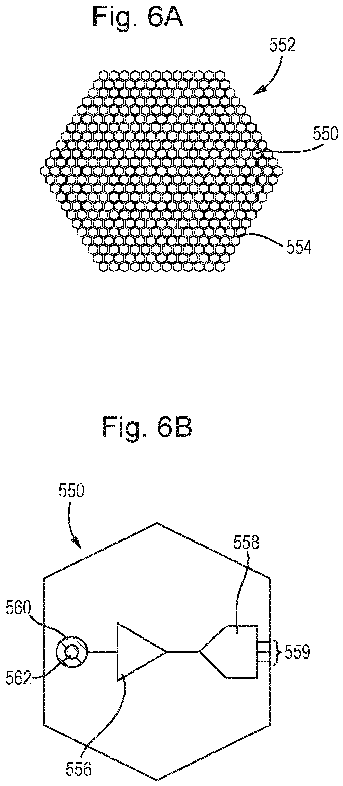

As shown in **FIG. 6A** a surface of a detector array or detector module (desirably facing, even proximate in use to, a sample) features an array of detector elements (or an array of detectors). Each detector element is associated with an aperture. Each detector element is associated with an assigned surface area of the substrate of the detector module . As the substrate is layered, for example in having a CMOS structure, each layer within the substrate is positioned with respect to the respective detector elements, desirably proximately. Commercially available CMOS structures have a usual range of layers, for example three to ten, usually about five. (For example, two functional layers may be provided for ease of description, which may be referred to as circuitry layers. These two layers of wiring layer and logic layer may represent as many layers as required and each layer is not restricted to wiring or logic, respectively.) The number of layers is limited by commercial availability and any number of layers is feasible. However, in view of practicality, the substrate has a limited number of layers, in order for an efficient design the available space is limited.

Ideally a circuit layer of the substrate, which can be the wiring layer and/or logic layer, has a portion assigned for each detector element (or detector). The assigned portions of the different layers may be referred to as a cell 550. The arrangement of portions in the substrate for the full multi-beam arrangement may be referred to as a cell array 552. The cells 550 may be same shape as the surface area assigned for each detector element, such as hexagonal, or any reasonable shape that may tesselate and may all be similar in shape and/or area, such as a rectangular shape. Having a rectangular or rectilinear shape can more readily be used by placing and routing design. Such design is commonly implemented by software that is suited to define chips with an rectangular type architecture with orthogonal directions, than architecture requiring acute or obtuse angles such as in a hexagonal architecture. In **FIG 6A** the cells 550 are depicted as being hexagonal and the cell array 552 is depicted as a hexagon comprising individual cells. However, ideally each similarly located with respect to detector elements. Wiring routes 554 may connect to each cell 550. The wiring routes 554 may be routed between other cells of the cell array 552. Note: reference to wiring routes to be between cells of the array, it is intended that at least the wiring routes avoid the beam apertures of the array of apertures, e.g. defined through the cell array. In an arrangement circuit architecture, the cell size in at least the circuit layer may be reduced to accommodate the wiring routes, so that the wiring routes are routed between cells. Additionally or alternatively the wiring routes pass through the cells of the cell array, desirably towards the perimeter of the cells for example to reduce the interference of the wiring routes with other circuitry in the cells. Therefore reference to a wiring route between the cells encompasses: a wiring route between the circuitry of cells, a wiring route within cells, desirably towards the periphery of the cells and at least around the beam apertures through the cells and any intermediate variation. In all these arrangements, for example in a CMOS architecture, the wiring routes may be in the same die as the other circuitry which may define circuitry in the same cell as a portion of the wiring route, or circuitry in a cell around which the wiring route is routed. Thus, the cells and wiring routes may parts of a monolithic structure. The wiring routes 554 may signally connect the cells. Thus the wiring routes signally connect the cells 550 to a controller or data processor external to the cell array or even the substrate or detector module. The circuit layer may comprise a datapath layer for the transmission of sensor signals from a cell outward of the cell array.

The controller or data processor may before circuitry within the substrate or detector module, desirably external to the cell array for example as control and I/O circuitry (not shown). The control and I/O circuitry may be in the same die as the cell array; the control and I/O circuitry may be monolithically integrated with the cell array, for example in the same CMOS chip. The control and to I/O circuitry enables an efficient connection between the data from all the cells of the cell array 552. Consider for example an arrangement of around 3000 cells each having an 8 bit digital output. Such an arrangement would have around 22000 signals to the electronics located outside the CMOS chip. The standard way of doing this is to use a SERDES circuitry (serializer / de-serializer). Such circuitry would transform a large number of low data rate signals into a few number of high data rate signals by means of time division multiplexing. It is therefore beneficial to have control and I/O circuitry monolithically with the cell array, or at least in the detector module, than external to the detector module.

In embodiments the control and I/O circuitry may feature general supporting functions, such as circuitry to communicate with the electronics outside the CMOS chip to enable loading certain settings, for example for control of amplification and offset such as subtraction as described herein.

The circuit layer of a cell 550 is connected to a detector element of the respective cell. The circuit layer comprises circuitry having amplification and/ digitation functions, e.g. it may comprise a amplification circuit. Such a circuitry associated with the detector, e.g. in a cell, may comprise elements to process a detection signal detected by the respective detector element. Such circuitry may be considered to process the detection signal. Such circuitry may be referred to as a detector processing circuitry. A cell 550 may comprise a trans impedance amplifier (TIA) 556 and an analogue to digital converter (ADC) 558 as depicted in **FIG. 6B****.** A cell may comprise the detector processing circuitry associated with a detector element. This figure schematically depicts a cell 550 with an associated detector element such as capture electrode and a feedback resistor 562 connected to the trans impedance amplifier 556 and the analogue to digital converter 558. The digital signal lines 559 from the analogue to digital converter 558 leave the cell 550. Note that the detector element is represented as a detector element 560 and feedback resistor is shown associated with the detector area as a disc 562 rather than associated with the trans impedance amplifier 556. This schematic representation is to represent each of the detector element and the feedback resistor as an area to indicate their relative size.

The trans impedance amplifier may comprise a feedback resistor Rf 562. The magnitude of the feedback resistor Rf should be optimized. The larger the value of this feedback resistor, the lower the input referred current noise. Thus the better signal-to noise ratio at the output of the transimpedance amplifier. However, the larger the resistance, Rf, the lower the bandwidth. A finite bandwidth results in a finite rise and fall time of the signal, resulting in additional image blur. An optimized Rf results in a good balance between noise level and additional image blur.

To implement the design the circuitry i.e. the amplification circuitry associated with each detector element should be within the layers of the associated cell 550 and fit in the limited area available of the portions of each associated layer. A typical resistance of the feedback resistor Rf can be as high as 30 to 300MOhm. If such a resistor would be implemented as a poly resistor in a standard CMOS process the size of such resistor would be much larger than the area that is available in the CMOS layers of the cell 550. For example, a resistor of 300MOhm would consume around 500000 micron^2. This is about 130 times larger than the entire available area.

Typically, for example in CMOS architecture, such a large resistor would be made in a single layer for example of polysilicon. Usually there is a single layer of polysilicon. In some circumstances a layer could be provided having material capable of providing high resistor values, although with such a high aspect ratio (e.g. extreme length relative to width of the resistive structure in the layer) the reliability of the resistor remains. Even if the cell were to have multiple layers used for such a resistor, many more layers would have to be present than is readily available for example using CMOS technology. Additionally or alternatively, the meandering path through different layers would not mitigate the high aspect ratio and risk of variation in the resistance value would only be contributed by the interconnections between different layers. Such interconnects influence the variability of the resistance value of a resistor as a corner, as later described herein.

Note that such dimensions are calculated assuming a 180 nm technology node. Using 180 nm technology node is preferred to a smaller node for processing reasons. For instance interconnects in a 180 nm node are simpler to process.

Further if such a resistor were made, in whichever node, the reliability of the resistor specifications as well as the space available for the resistor may be challenging.

In a layered structure for chip architecture, such as CMOS, the components and features are defined as structures in a layer. The specification of a component is dependent on the material of the layer and the physical properties of the layer, the dimensions of the layer, specifically its thickness and the dimensions of the structure formed in the layer. A resistor may take the form of a long narrow path, route or wire. In view of space constraints, the path may be non-linear, having corners along its path. For such a long component, the width of the path in the layer may vary such as through manufacturing tolerances. A corner may provide greater variance than a linear section of the path, limiting the accuracy with which the resistor can be made in order to have a specified resistance. With many corners and a long length, a resistor having such topology may made with poor reliability so that the resistances for equivalent resistors in different cells of the cell array may have a large range.

Such a resistive structure has a large surface area. Additionally or alternatively, a resistor with such a large surface area would additionally have a capacitance which is undesirable; such a capacitance is referred to as a parasitic capacitance. Parasitic capacitances may undesirably contribute to noise and blur, influencing the balance between noise, blur and bandwidth optimization which is elsewhere herein described

The material properties of the layer can be modified chemically; however such modifications are unlikely to achieve the improvement of several orders of magnitude in size to fit into available space in the cell. Such modifications are unlikely to change the topography of the feedback resistor sufficiently so that has the required specification and can be made with the desired reliable accuracy.

Such requirements in reliability and size would enable the resistor to achieve its desired performance in terms of bandwidth, signal to noise ratio, and stability. Unfortunately these requirements cannot be met.

Alternative amplification circuitry is proposed which does not require such a large feedback resistor. Examples include a trans impedance amplifier with a pseudo resistor as a feedback element and a direct analogue to digital converter, obviating the need for a transimpedance amplifier. Two examples of a direct analogue to digital converter are: using a low duty cycled switched resistor, and using a reference capacitor. These examples are described in detail in European Application No. 20217152.6 filed on 23 December 2020, which is hereby incorporated by reference, particularly in relation to the use of a low duty cycled switched resistor and a reference capacitor. An optional arrangement is to remove the analogue to digital converter 558 from the cells 550 so that a circuit wire 570 connects the trans impedance amplifier 556 in the cell 550 with the analogue to digital converter external to the cell array 552, as described in European Application No. 20217152.6 filed on 23 December 2020. By removing the analogue to digital converter from the cell 550, there is more space available in the circuit layer of the cell 550 for a feedback resistor element. There is yet more space in the circuit layer of the cell 550 if the amplifier circuitry uses an alternative trans impedance amplifier circuit, for example if a trans impedance amplifier with a pseudo resistor is used as a feedback element. The example amplifier circuits described are just some of the suitable types of amplification circuitry that can be used. Other amplifier circuits may exist which achieve similar benefits to those described herein and which use similar circuit architecture for each cell as herein described.

Although it may be easier to fit the trans impedance amplifier 556 with a pseudo resistor feedback element and analogue to digital converter in the circuit layers of the cell, in an arrangement it is more practical for space constraints for the analogue to digital converter 558 to be external to the cell array 552. This is despite the use of a pseudo resistor in the feedback element of the trans impedance amplifier providing a gain of one to two orders of magnitude in area. One consideration to decide whether or not the analogue to digital converter 558 is external to the cell array 552 is the sub-beam pitch of the multi-beam. For example with a sub-beam pitch of between 50 and 100 micron, typically only 4000 square micron is available per layer of a cell for the circuitry including the amplification circuitry.

Under such space constraints, a trans impedance amplifier is located in the cell of each beam. The analogue to digital converter is located outside the array of sub-beams, i.e. outside the cell array. In an embodiment, the analogue to digital converter is present on the same die as the cell array, for example monolithically with the cell array. Such an analogue to digital converter may be located with the control and I/O circuitry which may be on the detector module or even monolithic with the cell array 552. Locating the analogue to digital converter external to the cell array may provide an area gain of about a factor of two.

The circuit wire 570 connects the trans impedance amplifier in a cell 550 with the associated analogue to digital converter 558. The circuit wire 570 transmits an analogue signal. Unlike a digital signal, a data path transmitting an analogue signal is susceptible to interference. Signal interference can be from cross-talk with other circuit wires and from external fields such as generated by the sub-beams of the multi-beam and fields from nearby charged particle optical components such as the objective lens array 241.

The circuit wire 570 is routed through the a wiring route 554 as depicted in **FIG. 6A****.** The wiring route 554 is routed between cells so that the area of a cell and its layers is used for the amplification circuitry present on a cell. The wiring route 554 therefore only uses a portion of the circuit layers in which the wiring route is present, namely between adjoining cells 550 (e.g.. at least around the beam apertures 504, 406 of the adjoining cells 550; through the adjoining cells 550 such as towards the periphery of the cells or between the circuitry in a layer assigned to the adjoining cells 550, or any arrangement between the stated arrangements). This routing avoids architectural interference of the amplification circuitry and the architecture of the wiring routes 554. Circuit wires are routed along the wiring routes in the cell array in an outward direction, for example in a radially outward direction. With greater proximity to a perimeter of the cell array 552, there may be more circuit wires 570 than in a portion of the wiring route 554 remote from the perimeter. The wiring route may have a plurality of circuit wires 570, which as described, is between cells of the array. Therefore a portion of the wiring route 554 may have more than one circuit wire 570. However, having circuit wires located close to each other risks crosstalk between the circuit wires and interference of the analogue signals transmitted by the circuit wires 570.

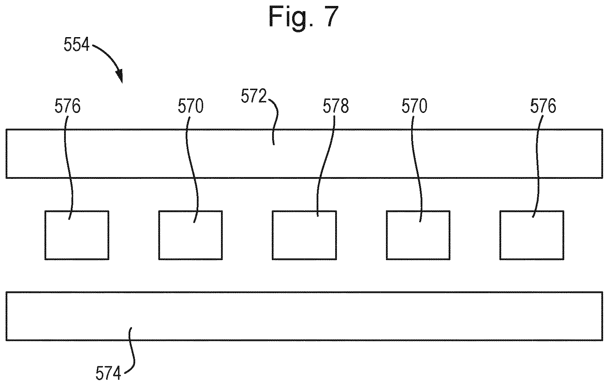

The risk of crosstalk and signal interference may be at least reduced or even prevented by having the circuit wires 570 shielded from each other within the wiring route. **FIG. 7** depicts cross-section of an exemplary arrangement of wiring route 554. Within the wiring route 554 are one or more circuit wires 470, shown extending in same direction as the wiring route 554 and a shielding arrangement. The circuit wires are shown in the same layer. Above the circuit wires 570 is an upper shielding layer 572; beneath the circuit wires 570 is a lower shielding layer 574 (or more down-beam shielding layer 574). The upper and lower shielding layers of the shielding arrangement shield the circuit wires 570 from fields external to the wiring route 554 above and beneath the wiring route 554. The shielding arrangement has shielding elements in the same layer as the circuit wires 570. The shielding elements may be outer elements 576 at the outer edges of the layer comprising the circuit wires 570. The outer elements 576 shield the circuit wires 570 from fields external to the wiring route 554. The shielding elements may include intermediate shielding elements 578 that are present in the layer between adjoining circuit wires. The intermediate shielding elements 578 may therefore at least suppress if not prevent cross-talk between the circuit wires 570. In operation, a common potential is applied to the shielding layers 572, 574 and shielding elements 576, 578. The potential may be a reference potential for example a ground potential.

Although **FIG. 7** depicts a three layer arrangement, as many layers may be used in the wiring route 570 as may be desired. For example, there may be two layers of circuit wires, requiring three shielding layers which include an upper shielding layer 572, a lower shielding layer 574 and an intermediate shielding layer. The intermediate shielding layer may additionally reduce if not prevent crosstalk between the circuit wires in the different layers of the wiring route 570. Thus, there are five layers in total. Every additional layer of circuit wires requires an additional intermediate shielding layer. Whereas increasing the number of layers in the wiring route 554 reduces the proportion of a layer that wire routing requires, such a variation in design requires additional layers. In view of the limited number of layers, there is an optimum number of layers at which the width of the wiring route is reduced without exceeding the number of layers required elsewhere in the substrate of the detector module, which can be limited to five layers.

A further consideration of the design of wiring route is the number of circuit wires that may need to be present in an exemplary design of detector module, for example consider the arrangement of **FIG. 7** with all circuit wires 570 in a layer.

For example, an array of sub-beams is arranged an hexagonal array with thirty (30) rings of sub-beams, for example arranged concentrically. The detector module therefore has a cell array of corresponding design. The number of cells is around 3000. Such a cell array may have a pitch of fifty to two hundred micron.

The outermost ring has the highest number of signals that need to be routed through the ring. Considering the wiring route is routed between cells of the cell array, all the signals of the cells are routed through the outermost ring, between the cells of the outermost ring. In this example the outermost ring consists of 180 cells, so the number of signals transported through the outermost ring, e.g. between the cells of the outermost ring, is approximately 2600. Thus, the maximum number of signals to be routed through the outer ring between adjacent cells is the total number of signals divided by the number of cells in the outermost ring (e.g. around 180). This is fifteen 15 (rounded up to the nearest whole number). Since the wiring route has a shielding arrangement to ensure that the signals are well shielded, e.g. limiting crosstalk and the influence of external fields, there may be sixteen shielding elements, including fourteen (14) intermediate shielding elements and two outer shielding elements 576. Therefore between adjacent cells 550 of the outer ring of the example, a wiring route having all circuit wires in the same layer would have thirty-one (31) elements of alternate shielding elements and circuit wires.

For cell array 552 for a beam array with a pitch of between 50 and 100 microns, there is enough space, or area, available in the circuit layer, for such a wiring route 554. In a structure created using a process at the 180nm node, the minimum half pitch of a metal layer is typically around 280nm. In this context a half pitch is a line and a pitch is the line with an associated gap with an adjoining gap. The associated gap is typically the same width the line. The wiring route for thirty-one elements requires thirty-one pitches. However, the associated gap of one of the elements, that corresponds to the outer elements 576, is not part of the wiring route 554, but would separate the wiring route from adjoining circuitry. Therefore, for thirty one elements, sixty-one (61) half pitches are required, which corresponds to a width of the circuit wiring 554 of approximately 17.1 micrometers.

The optimization of the noise performance for example in terms of bandwidth and noise optimization and balance between the blur and the noise can be enabled by making sure an amplification factor of the trans impedance amplifier is programmable. In a such an arrangement, the amplifier circuit of the cell, at least the trans impedance amplifier, is programmable. Such a programmable amplification circuit may comprise a variable amplifier and/or a variable analogue to digital converter for example. in terms of its sensitivity.. The variable amplifier has a variable amplification range dependent on a detected beam current detected by a detector element503. For example, when the detected beam current is low, or for a sample with a lower than typical secondary emission coefficient, the variable amplifier can be adjusted to provide a larger amplification than normally used. When a larger beam current than normal is detected by a detector element 503, or for a sample with a larger than typical secondary emission coefficient, the variable amplifier can be tuned to provide a smaller amplification.

This functionality is beneficial with a trans impedance amplifier with a feedback element having pseudo resistor. A pseudo resistor has different effective resistances on application of different applied voltages; unlike an ideal resistor which has a single resistance at all applied potential differences. In providing different resistance, the trans impedance amplifier associated with the pseudo resistor operates as a variable amplification. In providing an amplifier with variable functionality, an optimized balance between noise levels and image blur (referred to herein above as 'additional blur') may be achieved. Beneficially, the programmable amplification circuit may match the output of the trans impedance amplifier with the input of the analogue to digital converter. This may be as a programmable offset that is subtracted between the output of the trans impedance amplifier, and the input of the analogue to digital converter. The programmable offset may help reduce the required number of bits that need to be transmitted from the amplification circuit of a cell. The programmable offset may be implemented in the programmable amplifier. These measures help to ensure that the dynamic range of the trans impedance amplifier and the analogue to digital converter, and thus desirably the amplification circuit, are optimally used for different use cases. Such different use cases may include: the material properties of a sample under inspection, different assessment tool configurations for example using different beam currents. The range of applications may be enabled by the provision of a variable amplifier and a variable off set or threshold (e.g. subtraction by a programmable offset) desirable enables tuning of amplification, threshold and bandwidth As mentioned elsewhere herein, the circuitry associated with variable amplification and subtraction may be comprised in the control and I/O circuitry.

Known CMOS chips which are dedicated to image sensing have built in testing for pixel matrix stimuli, wherein a pixel is representative of a detection signal from a detector at a moment time. That is a pixel of data is generated by each detector element at a moment in time. These stimuli are typically designed with an analog mux that consists of a decoder and analog switches. Although this technique is well-known, analog switches suffer from current leakage (in the order of pA to nA) which may depend on temperature and switch size. Thus, use of analog switches can change the circuit characteristics (e.g. pA leakage and/or level of the signal). The pixel matrix for signal charged particle detection, and in particular for secondary charged particle detection, in multi-pixel applications operates under high temperatures (e.g. at least 85°C). Furthermore, the target amplification may use a current amplification in the order of pA. This means that an analog switch connected to the electronics under test may leak currents in the same order of magnitude as the signal being tested.

Another method for pixel stimuli is use of an electron beam that can illuminate the target pixel, i.e. to carry out verification via a charged particle beam. However, this stimuli is complex to develop and requires a long time to scan all the pixels of a detector matrix. Such a process has a highly complex set up and a high cost.

Alternative ways of testing detectors for use in a charged particle-optical device for example for assessment may be beneficial in providing a simpler testing set up. A simpler testing set up may reduce the time required to set up and test a detector, may reduce the costs of testing, and/or may reduce or avoid current leakage.

In the present invention, a detector can be interrogated and verified. A component (e.g. coupler or shield electrode described below) is used to stimulate a detector element (e.g. one that normally collect electrons). To test the detector element and any corresponding circuitry (e.g. the amplifier, ADC and/or any other intermediate elements between the detector element and the output), an output can be read out from the detector in normal way e.g. digitally. Thus, the testing is not just about verifying the detector elements but also the whole chain of electronics of the detector. If all works correctly, this will be reflected by the output, and the detector is verified. However, if any one component (e.g. the detector element or part of the detector circuitry) is not working properly, this will be reflected by the output. For example, an error message may be emitted. A diagnosis may or may not be supplied, as this will depend on the signal resulting in the output.

The detection circuit may be from a detector element to an amplifier (e.g. TIA 556) and an analogue to digital converter 558 to an output. Between every two components in the chain it is possible to couple signals. Thus, it is possible to have a coupler (or alternative component) coupled by a capacitive and inductive coupler. Thus coupling contactlessly inductively or capacitively is possible with elements of the circuit for any type of detector element.

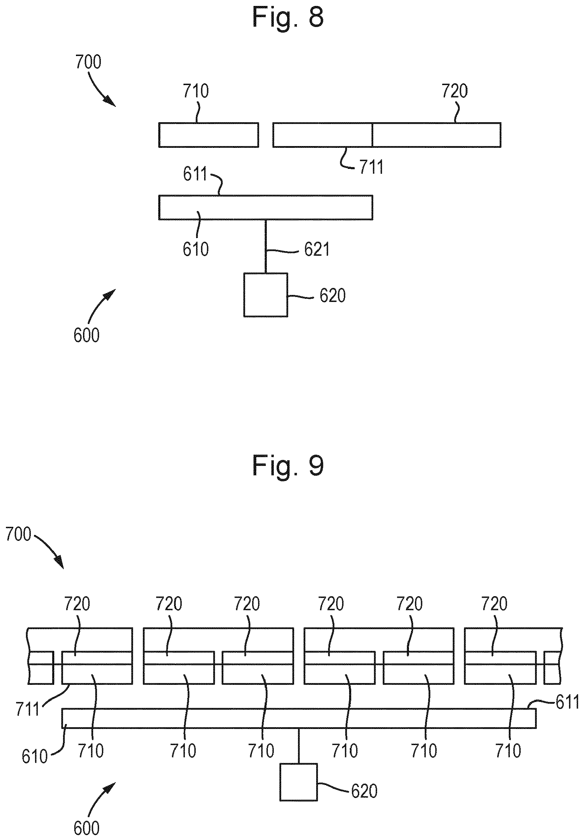

An embodiment of the present invention provides a detector inspection device 600. An example of the detector inspection device 600 is shown in **FIG 8****.** The detector inspection device 600 is suitable for interrogating at least part of a detector 700, wherein the detector 700 is comprised in a charged particle-optical device (e.g. an electron-optical column). The charged particle-optical device could correspond to the charged particle beam apparatus 100 for example for assessment, or more specifically the charged particle-optical device 40.

The detector inspection device 600 may be positioned in a variety of places, relative to the detector, wherein the detector 700 is desirably intended for, or part of, a charged particle optical device. The detector 700 may be at least one of the detectors of the detector array 240 described above. The detector inspection device 600 could be used for interrogating detectors which are to be used in other ways.

The detector inspection device 600 comprises a coupler 610 configured to be positioned proximate to a detector element 710 of the detector 700. The detector element 710 may be configured to detect signals, e.g. signal charged particles, from a sample as described above. The coupler 610 may otherwise be referred to as a charge coupler. The detector inspection device 600 further comprises a device controller 620 configured to apply a stimulating signal to the coupler 610 to stimulate a response signal in at least part of the detector 700 for interrogating at least part of the detector 700. The detector 700 can be interrogated by using the response signal, as described further below. The device controller 700 may be part of or separate from the coupler 610. The controller may be connectable to a controller of the charged particle optical device 40 or otherwise of the charged particle optical apparatus 100 or even the charged particle optical system.

The coupler 610 may be a conductive portion, i.e. capable of electrical conductivity. The coupler 610 may be formed of metal. The coupler 610 may be a metal portion. The coupler 610 may be a planar body, for example be a relatively thin plate which is electrically connected to the device controller 620.

The detector inspection device 600 may be used with a detector 700 to be interrogated. Desirably the detector element 710 can be exposed to the coupler 600, as shown in **FIG 8****.** Thus, at least a portion of the detector element 710, which is a conductive portion, is exposed to at least a part of the coupler 610. The detector element 710 of the detector to be interrogated is a conductive portion. The detector element 710 may be a charge based detector (which may otherwise be referred to as a charge detector element). For example, the detector element 710 may be a metal layer of a surface of the detector which may be configured to receive signal particles. As described below, the detector may comprise additional types of detector, which are desirably stacked within the detector in the beam path direction. Thus, even if other types of detector are provided, desirably the detector element 710 forms a layer on the detector 700 which provides a main surface, for example an exterior surface, of the detector 700. The main surface of the detector 700 may face towards the position 208 of a sample during assessment of the sample 208

The stimulating signal may stimulate a response signal in the detector 700 by various means, for example, by capacitive simulation or inductive stimulation. Thus, the coupler 610 may otherwise be referred to as a capacitive coupler and/or an inductive coupler. Beneficially, using capacitive or inductive stimulation means that the coupler does not need to contact the detector. Thus, the coupler 610 can be a contactless coupler which generates response signals in the detector 700 without contacting the detector 700. Providing a coupler 610 which does not contact the detector 700 may be beneficial in reducing damage to a surface of the detector 700 (where damage to the detector surface may affect functionality of the detector 700). In particular, this may prevent damage to the surface of the detector element 710. If there is direct physical contact between the coupler 610 and the detector 700, one or both of the coupler 610 and the detector 700 can become scratched. Direct contact may generate particles which is undesirable, especially if the detector inspection device is used within the particle-optical apparatus 100.

As described above, the device controller 620 can apply a stimulating signal to the coupler 610. Thus, the device controller 620 may be configured to control current and/or potentials applied to the coupler 610. Specifically, the device controller 620 may provide a stimulating signal with a varying current. Desirably, the stimulating signal has an alternating current. When the stimulating signal of varying current is provided to the coupler 610, the coupler 610, which is positioned proximate to the detector element 710, capacitively stimulates a response signal in the detector 700. More specifically, the varying stimulating signal in the coupler 610, when positioned proximate to the detector element 710, results in a corresponding response signal being generated in the detector element 710 due to capacitive coupling. The response signal can be detected and used for interrogating the detector 700. As described further below, the response signal is a test signal which can be used for verifying the detector 700. Thus, the response signal can be analysed to achieve verification of the detector 700.

The stimulating signal may have a varying voltage, desirably an alternating voltage. Thus, the stimulating signal may be configured to inductively stimulate a response signal in the detector 700. In other words, variation in the voltage of the stimulating signal may be controlled to stimulate the response signal in the detector 700 by a slightly different mechanism than when the current is varied. The stimulating signal may have a varying current, desirably an alternating current, and a varying voltage, desirably an alternating voltage. It is noted that voltage variation produces current and current variation produces voltage. However, the stimulating signal can be controlled depending on which parameter is controlled, e.g. voltage and/or current.

As described, the coupler 610 is proximate to the detector element 710. This may mean that the coupler 610 is adjacent to the detector element. This may mean that the coupler 610 is adjoining to the detector element 710, although desirably not in contact with the detector element 710. The coupler 610 may be offset from the detector element 710, for example, in the direction of the primary beam(s) path. Thus, the coupler 610 may be positioned with a gap between the coupler 610 and the detector element 710. This means that the coupler 610 and the detector element 710 are not in contact. This is desirable because a direct electrical connection between the coupler 610 and the detector element 710 would overload the electric circuitry. This is also desirable because contact between the coupler 610 and the detector element 710 might damage the detector element 710. Although this is desirable, it is not a necessity, as the coupler 610 could be positioned relative to the detector element 710 such that contact with the detector element 710 only affects a non-significant surface of the detector element, e.g. a side surface of a respective detector element, for example, if the coupler 610 is positioned laterally to the detector element. The coupling between the coupler 610 and detector 700 may generally be improved when the coupler 610 is close to the detector element 710. Thus, it is beneficial for the coupler 610 to be proximate to the detector element 710.

If contact is made between the coupler 610 and the detector element 710, the stimulation still works. If the detector and coupler are in contact, the signal into the electronics connected to the detector might be overloaded. The capacitance between detector and coupler normally attenuates the signal. That attenuation would be absent if there was a direct contact between them. Thus, the controller has to limit the signal injected in the detector.

The coupler 610 may be positioned as shown in **FIG 8****,** to be facing the detector element 710. The coupler 610 may comprise a facing surface 611 configured to face the detector element 710, as shown in **FIG 8****.** Desirably, the coupler 610, and particularly the facing surface 611, is adjacent to the detector element 710. Ideally, there are no components between the facing surface 611 of the coupler 610 and the detector element 710. As shown in **FIG 8****,** the facing surface 611 of the coupler 610 may be facing a main surface 711 of the detector element 700. There is a direct line (or direct line of sight) from any part of the main surface 711 and the facing surface 611. The main surface 711 of the detector element 710 may be the surface via which signal charged particles are generally detected during normal use of the detector 700.

The coupler 610, or at least the facing surface 611 of the coupler 610, may be shaped to match at least a portion of the detector element 710. Desirably, the coupler 610, or at least the facing surface 611, may be shaped to match the whole detector element 710, for example as shown in **FIG 8****.** For example, if the detector element 710 is a ring-shaped detector element 710, the coupler may be circular or ring shaped. Of course, any appropriate shape of detector element 710 and/or coupler 610 may be used, e.g. oval, triangular, rectangular, square, hexagonal, etc.. If the detector element 710 is a zoned detector element as described above in relation to FIGs 5A and 5B, the coupler may be shaped to match a single zone of the detector element, or multiple zones of the detector element, or the whole detector element.

The detector inspection device 600 may be configured to stimulate one detector element 710 at a time. For example, when the detector element 710 is provided as a single detector element as shown in **FIG 8****.** When the detector element 710 is a zoned detector element, the detector inspection device 600 may be configured to stimulate a single zone of a detector element 710 or simultaneously stimulate (i.e. at one time) multiple zones of a detector element 710. The detector inspection device 600 may be configured to stimulate simultaneously all the zones of a single zoned detector element at one time.

As shown in **FIG 8****,** the coupler 610 and the device controller 620 can be connected with a cable 621 (i.e. a wire). Although, it will be noted that the coupler 610 and device controller 620 could be formed as a single unit. Thus, the device controller 620 could be partially comprised in the coupler 610. Thus, the device controller 620 and the coupler 610 could be integral with each other. The device controller 620 may be in electrical contact with the coupler 610 in any appropriate way. The device controller 620 may be positioned anywhere as long as it is feasible to connect the device controller to the coupler 620.

The detector 700 may further comprise circuitry at least a part of which is detector processing circuitry and at least part of which is verification circuitry. Together the detector processing circuitry and optionally at least a part of the verification circuitry may comprise detector circuitry 720. As mentioned above, the detector processing circuitry is configured to process a detection signal or at least a signal generated in the associated and connected detector elements. The detector processing circuitry may comprise any or all of the components described above in relation to **FIGs 6A, 6B** **and/or 7.** The verification circuitry is configured to verify the detector 700, i.e. to ensure that the detector 700 is functioning/working as intended. The detector circuitry 720 may desirably be comprised in a substrate of the detector 700. The verification circuitry 720 may be configured to verify the detector 100 based on the response signal. Desirably the verification circuitry comprises detector circuitry associated which each detector element 710, for example, as shown in **FIG 8** for the single detector element. Alternatively, verification circuitry 720 is comprised with detector circuitry associated which each detector element 710. If the detector element 710 is a zoned detector the detector may comprise circuitry associated with each individual zone of the detector element or alternatively a detector element for each zone of a zoned detector (for example, for an array of detector elements with a single aperture, each element of the detector is a zone, and yet is a detector element). The circuitry associated with each individual zone may comprise at least part of the verification circuitry for the associated zone of the zoned detector.

Verifying the detector 700 may comprise verifying the detector element 710. Verifying the detector 700 may comprise verifying the detector circuitry 720, at least the detector processing circuitry which processes a detection signal from the detector element. Generally for verification, what is tested is the chain between the detector element and an output via the detector circuitry. Desirably the verification circuitry itself is not tested. Verifying the detector circuitry 720 (or at least the detector processing circuitry) comprises verifying any corresponding software - that has the functionality of the corresponding software). Desirably the circuitry comprises verification circuitry configured to verify the detector element 710 and/or the detector circuitry 720 (or at least the detector processing circuitry). It is beneficial to verify the detector circuitry 720 (or at least the detector processing circuitry) to determine if the detector 700 is functioning correctly, e.g. to correctly detect signal charged particles.

Verification of the detector 700 may verify the detector element 710 and/or the detector circuitry 720 (or at least the detector processing circuitry) associated with that (stimulated) detector element 710. The verification of the detector may be of any part of the circuit through which the detection signal may pass or be processed by. Desirably, verification of the detector 700 comprises verifying the detector circuitry 720. The device controller 620 may be configured to verify the detector 700 based on the response signal. Thus, the response signal can be used to check that at least part of the detector 700 is functioning. The device controller 620 may be configured to verify the detector 700 by comparing one or more parameters of the response signal with a specification for the one or more parameters. The specification of the one or more parameters may be referred to as reference parameters. Reference parameters might include, but are not limited to, TIA output voltage (i.e. output voltage of an amplifier associated with the detector element), TIA frequency response, TIA linearity, ADC output bits (i.e. relating to the digital output associated with the detector element), signal to noise ratio of the TIA (i.e. signal to noise ratio of an amplifier associated with the detector element), amplification factor, bandwidth. The parameters of the response signal may be checked against the specification by determining if the one or more parameters is at least equal to the specification for example the respective one or more reference parameters. If the one or more parameters is at least equal to the specification (e.g. the one or more respective reference parameters), the detector can be verified (i.e. is functioning within an acceptable range of the specification, e.g. working correctly). However, if a single one of the parameters is less than the corresponding parameters of the specification (i.e. reference parameters), the detector 700 may not be verified.

The detector inspection device 600 may be used in many different types of apparatus and system. For example, the detector inspection device 600 may be used in a charged particle-optical device, e.g. as part of charged particle beam apparatus 100 for example for assessment, or more specifically the charged particle-optical device 40, and/or as part of an optical lens array assembly. The coupler 610 and/or detector 700 may be part of a larger system or device. For example, the coupler 610 may be a lens electrode of a charged particle optical-assessment apparatus. The detector inspection device 600 may be configured to be removably insertable into a charged particle-optical device (e.g. an electron optical column). Thus, the detector inspection device 600 may be provided or used in conjunction with a charged particle-optical device, and the can be removed afterwards without damaging the charged particle-optical device, i.e. without damaging an element or component of the charged particle-optical device.

Although **FIG 8** shows that the facing surface 611 of the coupler 610 faces the main surface 711 of the detector element 710, it will be understood that the coupler 610 could be provided in various other positions. For example, the coupler 610 could surround the detector element 710. For example, the coupler 610 may have an annular shape and may be in the same plane as the detector element 710. In this case, the coupler 610 may be concentric with an outer perimeter of the detector element 710 in plan. The coupler 610 could be laterally positioned relative to the detector element 710. Thus, the coupler 610 could be positioned to the side of the detector element 710 and may be in the same plane as the detector element 710. In this instance, the facing surface 611 of the coupler 610 may face a side surface of the detector element 710. This may mean that a smaller area of the coupler 610 and the detector element 710 are facing each other. This may reduce the size of the response signal in the detector 700, for example for a given stimulating signal of the coupler 610. Typically to ensure that the response signal in the detector 700 is sufficiently large for verification of the detector, the stimulating signal is higher for a coupler 610 of smaller area; that is given all other parameters and variable remain the same. As a consequence, the device controller may be adapted to provide and withstand a greater stimulating signal. Providing the coupler 610 in such positions might be beneficial in more easily positioning the coupler 610, depending on the configuration of the detector 700. However, the coupler 610 being provided in a position to face the 711 main surface of the detector element 710 (as in **FIG 8**) may be preferred as it may be more effective in stimulating a response signal in the detector 700.

Although the coupler 610 in **FIG 8** is separate from the detector 700, the detector inspection device 600 may be further connected to the detector 700. For example, the device controller 620 may have a wired connection to the detector element 710. For example, the device controller 620 could be integral with the detector 700 in some way and the device controller 620 may be configured to control the coupler 610 and the detector 700, or more specifically the detector element 710. For example, the device controller 620 could be configured to control potentials applied to the detector element 710. Furthermore, the coupler 610 could be provided integrally with the detector 700. Desirably, the coupler 610 does not physically contact a detector element 710 of the detector, but is positioned to interact with the detector 700 as described above in relation to **FIG 8****.**

Although **FIG 8** is shown with only a single detector element 710, the detector 700 may comprise multiple detector elements, i.e. an array or detector elements as shown in **FIG 9****.** In this case, the coupler 610 may be shaped to match at least part of multiple detector elements 710. The coupler 610 may be larger than a single detector element 710. Thus, the coupler 610 may have a facing surface 611 which is larger than a facing surface 711 of a single detector element 710. The coupler 610 may be shaped to match multiple whole detector elements as depicted in **FIG 9****.** Thus, the coupler 610, or at least the facing surface 611 of the coupler 611, may still be shaped to match at least a portion of one of the detector elements 710 or a whole (i.e. single) detector element. Desirably, the coupler 610, or at least the facing surface 611 of the coupler 610 may be the same shape as the combined corresponding facing surfaces of multiple detector elements 710 of the detector 700. Although the coupler 610 is shown in **FIG 9** as matching the shape of three detector elements, the coupler 610 may be shaped to match any number of detector elements 710. The coupler 610 could be smaller than the coupler shown in **FIG 9** and, for example, may only correspond to a single one of the detector elements 710. When the coupler 610 is larger than the surface of any one detector element 710, the stimulating signal may generate a response signal the multiple facing detector elements 710. For example, in **FIG 9****,** the coupler 610 may be configured to stimulate a response signal in the three middle detector elements 710 (which include reference numerals).

Even when the detector 700 comprises multiple detector elements 710, the detector inspection device 610 may be configured to stimulate one detector element 710 at a time. For example, when the coupler 610, or at least the facing surface 611 of the coupler 610, is shaped to match a single detector element 710. Alternatively, the detector inspection device 600 may be configured to stimulate one detector element 710 of the array of detector elements at a time. Additionally or alternatively, multiple detector elements 710 may be stimulated simultaneously, i.e. multiple detector elements may be stimulated at a time. The multiple detector elements 710 may be stimulated selectively, for example in different groups of detector elements for example by regions of the detector for example detector elements arranged in groups corresponding to the different regions. At least one detector element may be stimulated selectively by applying a stimulating signal to multiple detector elements and disabling selectively at least one or more of these detector elements to measure a single one or multiple of the stimulated detector elements. Additionally or alternatively, the coupler 610 could be moved to the detector element(s) to be tested, and in this way test detector element(s) can be selectively stimulated.

As shown in **FIG 9****,** the detector 700 may comprise detector circuitry 720 associated with each detector element 710, i.e. each detector element 710 may have corresponding detector circuitry 720 specific to that detector element 710. Such a detector circuitry is connected to no other detector elements. The detector circuitry 720 for separate detector elements may be electrically connected to each other.

An alternative embodiment is described below wherein the coupler 610 is provided as a shield electrode in a detector assembly. It will be understood that the shield electrode may have some, if not most, of the characteristics described above for the coupler 610, examples of which are shown in **FIGs 8 and 9****.** (Such characteristics disclosed and described with respect to **FIGS 8 and 9** apply to this arrangement unless otherwise stated to the contrary). Other components of the detector assembly may have some, if not most, of the characteristics described above for corresponding features.

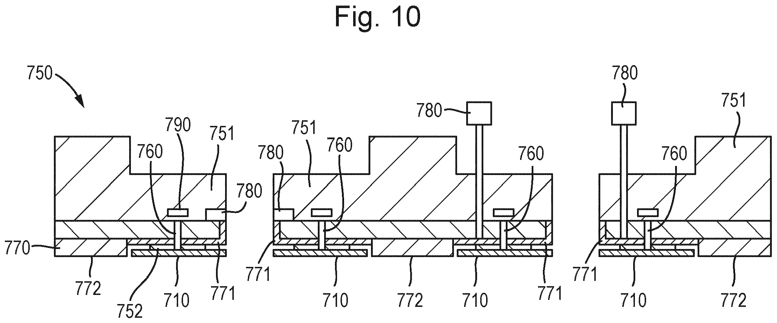

In this embodiment, a detector assembly 750 is provided, for example as shown in **FIG 10****.** The detector assembly 750 is suitable for use in an assessment apparatus for projecting a charged particle beam towards a sample. The assessment apparatus may be single beam or multi-beam, and variations of the detector assembly are described below; although the detector assembly 750 depicted is for a multi-beam because it has two detector elements 710 each associated with an aperture through the detector assembly (i.e. more than charged particle beam). The charged particle-optical apparatus could correspond to the charged particle beam inspection apparatus 100, or more specifically the assessment device 40.

The assembly 750 comprises a detector and a detector controller 780. As will be described, the detector controller 780 may take on the function of the device controller 620 as shown and described with respect to **FIGs 8 and 9** and such description also applies to the detector controller unless stated otherwise to the contrary. The detector comprises a detector element 710 and a shield electrode 770. The detector element 710 may be similar to the detector element 710 described for use with the detector inspection device 600 as described above. The detector element 710 is configured to detect signals from a sample, as described above. The detector element 710 may be the same as the detector element 710 described in the embodiment above. For example, detector element 710 may comprise or be a conductive portion. The detector element 710 may be a charge based detector. For example, the detector element 710 may be a metal layer of a surface of the detector which may be configured to receive signal particles. The detector element 710 may be configured to be exposed to the shield electrode. The conductive portion may be in electrical communication with circuitry.

The shield electrode 770 may be configured to shield elements within the detector assembly, e.g. to shield components of the detector assembly 650 from the detector element 710 and from charged particles. The shield electrode may be similar to the coupler 610 described above. For example, the shield electrode 770 may be a conductive portion, i.e. capable of electrical conductivity. The shield electrode 770 may be formed of metal. The shield electrode 770 may be a metal portion. The shield electrode 770 may be a plate (that is desirably relatively thin) which is electrically connected to the detector controller. The shield electrode 770 may be separate portions, for example as shown in **FIG 10****.**

At least a portion 771 of the shield electrode 770 is positioned proximate to the detector element 710. This may mean that at least a portion of the shield electrode 770 is adjacent to the detector element 710. This may mean that at least a portion of the shield electrode 770 is adjoining to the detector element 710, although desirably not in contact with the detector element 710. As shown in **FIG 10****,** at least part of the shield electrode 770 may be offset from the detector element 710, for example, in the direction of the primary beam(s) path. Thus, at least part of the shield electrode 770 may be positioned with a gap between the shield electrode 770 and the detector element 710. This means that the shield electrode 770 and the detector element710 are not in contact. This is desirable because contact between the shield electrode 770 and the detector element 710 might damage the detector element 710. The coupling between the shield electrode 770 and detector may generally be improved when the shield electrode 770 is close to the detector element 710. Thus, it is beneficial for the shield electrode 770 to be proximate to the detector element 710. The shield 770 and verification circuitry may be referred to as the verification system. The verification system may comprise the detector controller. The verification system associated with a detector element may be associated with one or multiple detector elements.

As described above, at least the portion 771 of the shield electrode 770 may be offset. At least the portion 771 of the shield electrode 770 may be substantially parallel and adjacent to the detector element 710. Desirably, a surface of the portion 771 of the shield electrode 770 is coplanar with a surface of the detector element 710. Desirably, a surface of the portion of the shield is further from a major surface of the detector substrate than the surface of the substrate. Desirably, the surface of the portion 771 of the shield electrode 770 is positioned further from a surface of a sample than a major surface of the detector element 710. Thus, at least part of the detector element desirably interposes between one of the portions of the shield and the sample position. In other words, the surface of the portion 771 of the shield electrode 770 may be positioned within the detector assembly 750 and may be further from the sample in use than the detector element 710. Desirably at least part of the detector element 710 interposes between one of the portions of the shield 771 and the sample position. Thus, when the detector assembly 750 is positioned relative to a sample, the detector element 710 is positioned between at least part of the shield element 770 and the sample.

The detector element 710 and the shield electrode 770 may be connected, desirably indirectly. For example, the detector may comprise an isolating element 752 between the detector element 710 and the shield element 770 as included in **FIG 10****.** For example, the isolating element 752 may be silicon oxide or any other appropriate material. Although **FIG. 10** includes a gap (i.e. the lateral recess) between the shield electrode 770 and the detector element 710, it is not necessary for such a gap to be provided. For example, the isolating element 752 could be shaped or configured to be positioned along a whole surface of the detector element 710, i.e. to provide material rather than vacuum between the detector element 710 and shield electrode 770.

The detector assembly 750 may have an operational state in which the detector element 710 detects signals from the sample, i.e. when the detector assembly 750 carries out the normal operation. In the operational state, the detector processing circuitry may process a detection signal. The detector assembly 750 may also have an interrogation state in which the detector element 710 is interrogated, i.e. when the detector element 710 is not used for detecting signals from the sample. In the interrogation state, the stimulating signal is applied to at least part of the shield electrode 770 so as to stimulate the response signal in the detector. In the interrogation state, the detector processing circuitry may process the response signal.

The detector assembly 750 comprises the detector controller 780 configured to apply a stimulating signal to at least part of the shield electrode 770 to stimulate a response signal in the detector for interrogating at least part of the detector. Thus, the detector controller 780 can apply a stimulating signal to the shield electrode 770 as described above in relation to the coupler. As described above, the shield electrode 770 may be configured to capacitively or inductively stimulate the response signal in the detector. The detector controller 780 may provide a stimulating signal with a varying current, desirably an alternating current, and/or the stimulating signal may have a varying voltage, desirably an alternating voltage. The response corresponding response signal can be analyzed to achieve verification of the detector.

The detector assembly 750 may comprise a plurality of detector elements 710, e.g. an array of detector elements. The detector assembly 750 shown in **FIG 10** includes 2 detector elements 710. The detector assembly 750 may include a greater number of detector elements, including any appropriate number.

The shield electrode 770 may be interposed between adjoining detector elements 710. For example, at least a part 772 of the shield electrode 770 may be positioned between adjacent detector elements. In **FIG 10**, the part 772 of the shield electrode 770 is interposed between the detector elements 710. In the plane of the main surface of the detector elements, the detector elements may all be separated from each other by at least part 772 of the shield electrode 770.

The stimulating signal may be applied to part of the shield electrode 770. For example, the stimulating signal may be applied only to the portion 771 of the shield electrode 770 which is offset from the detector element 710. The stimulating signal may be applied to the whole shield electrode 770, which is desirably around the detector element 710. Different portions of the shield electrode 770 may be in electrical connection with each other. Note that in applying the stimulating signal to a preferred portion of the shield electrode, for example a portion that is parallel with the detector elements, the stimulating signal may be applied to all portions of the shield electrode 770 that are in direct electrical connection with the preferred portion, for example in different groups for example the whole shield electrode 770. Alternatively, parts of the shield electrode may be electrically isolated from other parts of the shield electrode and the stimulating signal may only be applied to a specific part of the shield electrode 770.

The detector assembly 750 may be configured to stimulate one detector element 710 at a time, e.g. by stimulating only a single portion of the shield electrode 770. Alternatively, the detector assembly 750 may be configured to stimulate multiple detector elements 710 at a time. Thus, multiple detector elements may be selectively simultaneously stimulated. All the detector elements in an array may be stimulated simultaneously.

The shield electrode 770 may be made up of separate portions. The separate portions may be controlled separately, for example, the separate portions may selectively stimulate the detector elements as described above. The portions may be considered to be separate shield elements. The shield electrode 770 may comprise a shield element array. The detector controller 780 may be configured to apply the stimulating signal to individual shield elements, or to multiple shield elements, or to all shield elements to stimulate individual or multiple detector elements 710 as described above. Thus, the application of the stimulating signal to the shield electrode 770 can be controlled to specifically select which part of the shield electrode 770 (or which shield elements if relevant), have a stimulating signal for generating a response signal in the detector.

The detector controller 780 may be configured to control the shield electrode 770 and the detector, and desirably more specifically, the detector element 710. The detector controller 780 may be configured to control potentials applied to the detector, and desirably to the detector element 710. The detector controller 780 may have a wired connection to the detector element 710. Additionally or alternatively, the detector controller 780 may be configured to control potentials applied to the shield electrode 770. The detector controller 780 may have a wired connection to the shield electrode 770.

The detector may comprise a substrate 751, for example, as shown in **FIG 10****.** The substrate may comprise the detector element 710 and/or the shield element 770. Thus, the detector element 710 and/or the shield electrode 770 may be integral in a component. If an isolating element 751 is provided, this may also be integral in the substrate, for example between the shield electrode 770 and the detector element 710 or at least defining a surface between the shield electrode 770 and the detector element 710.

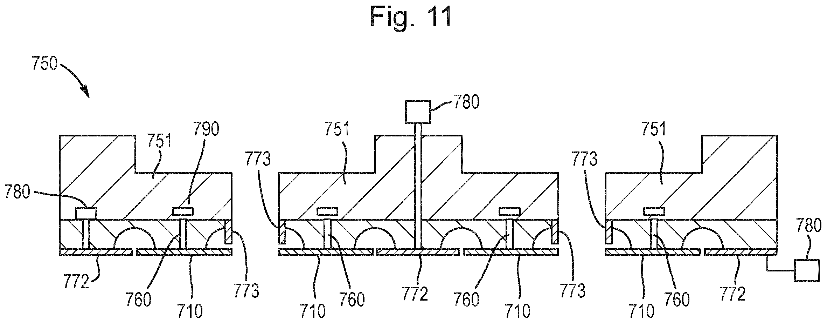

The detector controller 780 may be positioned in any appropriate location. A number of different locations are shown in **FIGs 10** **and** **11****.** It will be understood that the differing locations shown in **FIGs 10** **and** **11** are to display possible locations of the detector controller 780. The detector assembly 750 may include a detector controller 780 corresponding to each detector element 710. The detector controller 780 may be positioned in different locations relative to their respective detector element 710, such as shown in **FIGs 10** **and** **11****.** Alternatively, some or all of the detector controllers 780 may be positioned in the same location relative to their respective detector element 710.

The detector controller 780 may be connected directly or indirectly (e.g. via a wired connection) to the shield electrode 770. Additionally, the detector controller 780 may be connected directly or indirectly (e.g. via a wired connection) to the detector element 710.

For example, the detector controller 780 may be positioned within at least one other component of the detector assembly 750. For example, the detector substrate may comprise the detector controller 780. The detector controller 780 may be in contact with at least part of the shield electrode 770, as shown on the left hand side of **FIGs 10** **and** **11****.** The circuitry, for example a circuitry layer, of the detector assembly may comprise the detector controller 780. The detector controller 780 may be at least comprised in the detector circuitry 720 associated with each detector element 710, i.e. each detector element 710; that is the detector controller may be comprised in detector circuitry 720 specific to the corresponding detector element 710 that detector controller controls.

For example, the detector controller 780 may be positioned external to the substrate of the detector assembly 750, as shown on the right hand side of **FIG 10****,** in the middle of **FIG 11****,** and on the right hand side of **FIG 11****.** The detector controller 780 may be positioned above the detector assembly 750, on the opposite side of the detector assembly 750 to the detector element 710, as shown on the right hand side of **FIG 10****,** and in the middle of **FIG 11****.** The detector controller 780 may be positioned below the detector assembly 750, on the same side of the detector assembly 750 as the detector element 710, as shown on the right hand side of **FIG 11****.** In an arrangement the detector controller may be located elsewhere in the particle-optical device 40, or even elsewhere in the particle-optical apparatus 100 for example in a processing rack. In an arrangement the detector controller may be part of and/or may be a distributed control system with different parts of the controller or control system in different locations.

As shown in **FIGs 10** **and** **11****,** the shield electrode 770 and the detector controller 780 can be connected with a cable (i.e. a wire). Although, it will be noted that the shield electrode 770 and the detector controller 780 could be formed as a single unit. Thus, the detector controller 780 could be partially comprised in the shield electrode 770. Thus, circuitry associated with the shield electrode 770 and the detector controller 780 could be integral with each other. The detector controller 780 may be in electrical contact with the shield electrode 770 in any appropriate way. The detector controller 780 may be positioned anywhere as long as it is feasible to connect the detector controller 780 to the shield electrode 770.

As described above, the detector may further comprise circuitry at least a part of which is detector processing circuitry and at least part of which is verification circuitry. Together the detector processing circuitry and optionally at least a part of the verification circuitry may comprise detector circuitry 790. As described above, the detector processing circuitry is configured to process a detection signal or at least a signal generated in the associated and connected detector elements (for example, in an assessment state). The detector processing circuitry may comprise any or all of the components described above in relation to **FIGs 6A, 6B** **and/or 7.** The verification circuitry is configured to verify the detector, i.e. to ensure that the detector is functioning/working as intended. The detector circuitry 790 may have other functions, or different parts of it may have different functions. The detector circuitry 790 may desirably be comprised in the substrate 751 of the detector. The verification circuitry 790 may be configured to verify the detector based on the response signal. Desirably the verification circuitry comprises detector circuitry associated which each detector element 710. The verification circuitry 720 may be comprised with detector circuitry 790 associated which each detector element 710. If the detector element 710 is a zoned detector the detector may comprise circuitry, such as detector circuitry 790, associated with each individual zone of the detector element 710 or alternatively a detector element for each zone of a zoned detector (for example, for an array of detector elements with a single aperture, each element of the detector is a zone, and yet is a detector element). The circuitry, and more particularly the detector circuitry 790, may be positioned in an insulating body as shown in **FIGs 10** **and** **11****.** Desirably the circuitry is arranged to verify one or more detector elements. Verification circuitry may be used to verify one or more detector elements. The detector circuitry 790 may comprises may verification circuitry 790. Desirably verification circuitry comprises part of the detector controller 780. At least part of the detector circuitry 790 may comprise at least part of the detector controller 780. At least part of the detector controller 780 may be comprised in the detector circuitry 790 associated with a detector element, desirably the detector controller 780 is associated with and arranged to control the shield electrode 770 associated with at least the corresponding detector element. The detector controller may be comprised at least partly in circuitry associated with the shield electrode. The circuitry associated with the shield electrode and the detector element may be the same, desirably comprising the detector circuitry 790.

Verifying the detector may comprise verifying the detector element 710. Verifying the detector may comprise verifying the detector circuitry 790 (at least the detector processing circuitry which processes a detection signal from the detector element. Generally for verification, what is tested is the chain between the detector element and an output via the detector circuitry. Desirably the verification circuitry itself is not tested. Verifying the detector circuitry 720 (or at least the detector processing circuitry) comprises verifying any corresponding software. Desirably the circuitry comprises verification circuitry configured to verify the detector element 710 and/or the detector circuitry 790 (or at least the detector processing circuitry). It is beneficial to verify the detector circuitry 790 (or at least the detector processing circuitry) to determine if the detector is functioning correctly, e.g. to correctly detect signal charged particles.

Verification of the detector may verify the detector element 710 and/or the detector circuitry 790 (at least the detector processing circuitry) associated with that (stimulated) detector element 710. The verification of the detector may be of any part of the circuit through which the detection signal may pass or be processed by. Desirably, verification of the detector comprises verifying the detector circuitry 790. The detector controller 780 may be configured to verify the detector based on the response signal. Thus, the response signal can be used to check that at least part of the detector is functioning. The detector controller 780 may be configured to verify the detector by comparing one or more parameters of the response signal with a specification for the one or more parameters. The specification of the one or more parameters may be referred to as reference parameters. Reference parameters might include, but are not limited to, TIA output voltage (i.e. output voltage of an amplifier associated with the detector element), TIA frequency response, TIA linearity, ADC output bits (i.e. relating to the digital output associated with the detector element), signal to noise ratio of the TIA (i.e. signal to noise ratio of an amplifier associated with the detector element), amplification factor, bandwidth. The parameters of the response signal may be checked against the specification by determining if the one or more parameters is at least equal to the specification for example the respective one or more reference parameters. If the one or more parameters is at least equal to the specification (e.g. the one or more respective reference parameters), the detector can be verified (i.e. is functioning within an acceptable range of the specification, e.g. is working correctly). However, if a single one of the parameters is less than the corresponding parameters of the specification (i.e. reference parameters), the detector may not be verified.

The detector assembly 750 may be used in many different types of apparatus and system. For example, the detector assembly 750 may be provided or used in conjunction with a charged particle-optical device, e.g. as part of charged particle beam apparatus 100 for example for assessment, or more specifically the charged particle-optical device 40, and/or as part of an optical lens array assembly.

Although **FIG 10** shows that at least part of the shield electrode 770 faces the detector element 710 (such that they are coplanar) it will be understood that the shield electrode 770 could be provided in various other positions. For example, the shield electrode 770 may be in the same plane as the detector element 710. The shield electrode 770 could surround at least part of the detector element 710, for example as shown in **FIG 11****.** The shield electrode 770 may be laterally positioned relative to at least part of the detector element 710. Thus, the shield electrode 770 could be positioned to the side of the detector element 710. In this instance, the facing surface of the shield electrode 770 may face a side surface of the detector element 710. This may mean that a smaller area of the shield electrode 770 and the detector element 710 are facing each other. However the relative arrangement and positioning of the shield electrode 770 and the detector element 710 may be sufficient for a stimulating signal applied to the shield electrode 770 to induce a sufficiently large response signal in the detector element 710. In **FIG 11****,** a hemi-spherical recess may be provided which extends laterally behind the detector element and/or shield electrode 770 as shown. The recess could be provided in other shapes. Alternatively, the isolating element 752 could be shaped or configured to be positioned along a whole surface of the detector element 710 and/or shield electrode, i.e. to provide material rather than a gap behind the detector element 710 and/or shield electrode 770. **FIGs 10** **and** 11 are intended to provide example configurations of the detector assembly. However other configurations may be provided.

Although the detector assembly 750 described above (and shown in **FIGs 10** **and** **11****)** comprises multiple detector elements, this is not a necessity. The detector assembly 750 may comprise a single detector element 710. Such a detector element 710 may have a shield electrode 770, which is provided as a single element, or may comprise multiple elements (as described above), associated with the single detector element 710. A detector array may be provided comprising multiple detector assemblies 750. The detector assemblies 750 may be configured as described in any of the variations above. The detector assemblies may each comprise a single detector element 710. Alternatively, each detector assembly 750 may comprise multiple detector elements 710, e.g. an array of detector elements. Two or more of the detector assemblies may be located at different distances relative to a position of the sample. Alternatively, two or more of the detector assemblies 750 may be located at a similar distance from the position of the sample. Thus in the preceding description, where an arrangement of a detector assembly of a multi-beam arrangement is described with multiple apertures with associated detector elements, it should be understood that the disclosure also refers to a similar architecture for a single beam system with a single aperture and at least one detector element, unless stated to the contrary.

A detector array may be provided comprising a detector assembly 750 described above in which multiple detector elements 710 are included in a detector assembly 750. Thus, the detector assembly 750 may be provided as a detector array, wherein the detector array comprises an array of detector elements. Desirably, the shield electrode 770 comprises a shield element array, for example with at least one shield element for each detector element 710. The detector elements and/or the shield electrode(s) may be provided as part of the detector substrate.

In an embodiment, an assessment apparatus may be provided which is suitable for assessing the sample. Such an assessment apparatus may comprise a particle optical apparatus 100. Desirably, the particle optical apparatus 100 is suitable for projecting charged particles towards a sample. The particle optical apparatus 100 may be a single beam charged particle apparatus, The particle optical apparatus 100 may be configured to project a single beam of charged particles towards the sample. The particle optical apparatus 100 may be for multiple beams for example the particle optical apparatus 100 may be configured to project an array of beams of charged particles towards the sample.

The particle optical apparatus 100 may comprise the detector assembly 750 and/or the detector array as described in any of the above variations.

The particle optical apparatus 100 may comprise a sample support for supporting the sample. The sample support may correspond to the sample holder 207 described above. The assessment device may comprise a detector assembly 750 comprising a detector configured to detect signals from a sample supported by the sample support. The particle optical apparatus 100 may comprise a detector controller 780 configured to control and be in communication with the detector. The particle optical apparatus 100 may comprise the detector inspection apparatus as described in any of the variations above. The device controller of the detector inspection device may be configured to be in signal communication with the detector controller 780. The device controller and the detector controller 780 may be the same controller, or may be in signal communication, e.g. via a wired connection or wirelessly.

The detector assembly 750 of the particle optical apparatus 100 may be positioned such that the detector element 710 is facing the sample (when the sample is in position). Thus, the detector element 710 may be positioned to face the sample support. The detector element 710, when in position, may be proximate the sample.

When the detector inspection device is to be used with the particle optical apparatus 100, the detector element 710 may be positioned with enough space between the detector element 710 and the sample support so that the coupler can be positioned between the detector element 710 and the sample.

The detector assembly 750 can be associated with charged particle-optical components of a charged particle-optical device 40 of the particle optical apparatus 100. For example, the detector assembly 750 may be incorporated in the one or more charged particle-optical components. Thus, the detector assembly 750 could be integral with, or connected to, one or more charged particle-optical components. For example, the detector assembly 750 might be associated with an objective lens, desirably incorporated into the objective lens. Multiple detector assemblies could be provided and could be integral with different charged particle-optical components.

Desirably, the charged particle-optical device is a primary charged particle-optical device and the detector assembly 750 is associated with charged particle-optical components of a secondary device of the assessment apparatus. Such a charged particle optical device comprises a condenser lens and an objective lens. The condenser lens is up beam of the objective lens. At least one of the condenser lens and objective lens may be a macro lens. One or more of the condenser lens and the objective lens may be a magnetic lens. Between the condenser lens and the objective lens is a Wien filter. The Wien filter may permit charged particle beams to pass towards a sample without altering the path of the charged particle beam. However the Wien filter directs the paths of signal particles from the sample, which are generated on impact of the charged particle beam with the sample, towards the secondary device. The secondary device may comprise the detector assembly 750. The detector assembly 750 may be positioned at or towards a remote end of the secondary device from the Wien filter. The secondary column may comprise charged particle elements and components to operate on the paths of the charged particles towards the detector assembly 750. Such components may filter, correct aberrations, direct such as for alignment, focus and confirm alignment of the charged particle particles on the detector elements of the detector assembly. The detector assembly 750 of the secondary device may differ in being a monolithic detector face, or at least without apertures. The detector assembly has the same features as the detector assembly as shown in and described with respect to **FIGs 10** **and/or 11** except as otherwise described. The detector assembly may comprises two elements including a detector part and processing part each of which may be on chip (e.g. part of a substrate). The detector part may comprise one or more detector elements. The controller, detector circuitry and verification circuitry may be at least partly in the detector part and/or the processing part. In an arrangement, the detector assembly is monolithic comprising both the detector part and the processing part in the same chip. The detector elements of the detector assembly of this arrangement may comprise semiconducting detector elements such as PIN elements and/or electron to photon converter elements such as scintillator elements.

In the above embodiments, the detector may comprise one or more detector types. As described above, the detector may comprise a charge based detector. Additionally, the detector may further comprise a semiconducting element such as PIN type element and/or an electron to photon converter element (or 'converter element') such as a scintillator element. Thus, each detector may include a detector element 710 described in the above embodiments which includes a conductive portion, e.g. a charge based detector element, and another type of detection portion, such as the PIN type element and/or scintillator element. The different types of detector element may be integral with, or connected to the detector substrate. The performance of the detector circuitry, at least part of the circuity of the detector assembly, such as at least part of the detector circuitry for example the detector processing circuitry, may be tested by the detector inspection device 610 or the verification system. The detector circuitry of associated with a converter element and associated with a scintillating element may be verified even though these elements are non-responsive to application of a stimulating signal by the coupler or by a verification element. In this context, the coupler is external to the detector assembly; the verification element is internal to the detector assembly. The verification element may be a conductive layer proximate to the verification circuitry, such as in an adjoining yet isolated conductive layer within the detector assembly for example to the detector circuitry (or at least the part to be verified). The detector circuitry for example the detector processing circuitry may generate a response signal in response to a stimulating signal in the verification element. The generated response signal may be used to verify that the circuitry such as the detector circuitry, e.g. the detector processing circuitry, meets the desired specification.

In the above embodiments, the detector assembly comprises a detector element which is generally configured to detect signals from a sample, and is configured to respond to the stimulating signal. However, some types of detector element may be less suitable for being stimulated. In an alternative embodiment, the detector element may not be configured to respond to the stimulating signal, or may only have a very limited or weak response to the stimulating signal. For example, the detector element may comprise a semiconductor element, e.g. a PIN type element, and/or a converter type element, e.g. a scintillator. In this embodiment, the detector comprises a verification element configured to respond to the stimulating signal.

Thus, any of the above embodiments may be adapted to use a verification element configured to respond to signals (such as the stimulating signal), which can be used to verify the detector (instead of the using the detector element as in the above described embodiment). Thus, the verification element may be simulated to generate the response signal, e.g. due to capacitive or inductive coupling as described above. The verification element may be used only for verifying the operation. Such a detector may be used with the detector inspection device or the detector assemblies described above. In this case, the response signal can be used to verify the corresponding detector circuitry 790 (or at least the detector processing circuitry and any corresponding software). As mentioned and described at least with respect to a detector comprising a charge detector element and at least one of a converter element and a semiconducting element, the performance of the detector circuitry (or at least the detector processing circuitry) may be interrogated and verified.

The detector assembly may comprise a coupler as described above, which can be positioned proximate to the detector element during interrogation. A stimulating signal can be applied to the coupler to stimulate a response signal in the detector (via the verification element). The coupler may be the same as the coupler described in the above embodiments. The coupler may be the same as the shield element in the other embodiments. The shield electrode may be part of the detector, and for example, may be positioned relative to the detector element as described in the above embodiments.

The verification element may be associated with the detector element. For example the detector element may be positioned on, adjacent, and/or proximate to the detector element. The verification element may comprise a conductive portion configured to be exposed to the coupler. Preferably, the conductive portion of the verification element is in electrical communication and/or signal communication with circuitry, preferably the detector processing circuitry. This means that generation of a signal in response to the stimulating signal in the verification element can be electrically communicated to the circuitry, preferably the detector processing circuitry. This allows for verification of the circuitry, preferably the detector processing circuitry, as described in the above embodiments.

In any of the above embodiment, it may not be necessary for the detector element to be configured to detect charged particles from a sample. Instead for example, the detector element may be used for another type of detection mode, for example of the primary charged particle beam (or beams of a multi-beam device). The detected signal of the primary beam (or of the signal particles for that matter) may be used for monitoring the alignment of the charged particle beam or charged particle beams, or monitoring one or more other characteristics of the charged particle beam such as source beam uniformity and aberrations in the charged particle beam such as distortion, filed curvature, astigmatism and coma. The detected signal may be processed to obtain information about the charged particle beam. The information obtained may be used to control an electron-optical element of the particle optical device 40 to adjust one more properties of the charged particle beam. The detector inspection device or the detector inspection system within at least the detector assembly may be used to verify the detector, for example the detector elements and/or the detector processing circuitry.

The detector controller 780 and/or the device controller may be part of a larger controller. For example, the detector controller 780 and/or the device controller may be connected to, or in signal communication with controller 50. The detector controller and/or the device controller may be part of a generic controller, such as controller 50, and need not be a controller assigned specifically to the detector or device respectively. The detector controller 780 and/or the device controller may have components with which they are in signal communication which are outside of the substrate, or device, or assembly 750. Signal communication may be made wirelessly, or via a wired (i.e. cabled) connection. Thus, for example, only a part of the device controller and/or the detector controller 780 may be included in the detector substrate. The detector controller 780 and/or the device controller may have sub-controllers. For example, the detector controller 780 may have one sub-controller for the detector element and another sub-controller for the shield electrode 770.

In the above embodiments, the detector circuitry preferably comprises at least part of the detector controller, verification circuitry and/or detector processing circuitry.

The present invention may also provide a method of interrogating at least part of a detector for a charged particle-optical apparatus. The method may use any of the detector inspection device, or the detector assembly 750 (for example the verification system of the detector assembly 750), or the detector array, the charged particle optical device 40 or the charged particle apparatus 100 (or charged particle-optical system) as described above.

A method is provided of interrogating at least part of a detector for a charged particle-optical assessment apparatus. The method comprising generating a stimulating signal in a coupler; stimulating a response signal in the detector element in response to the stimulating signal; and detecting the response signal in the detector element. The method may further comprise applying a varying current, desirably an alternating current to the coupler. The method may further comprise applying a varying voltage, desirably an alternating voltage to the coupler. The couple may be provided as a shield electrode 770 in a detector assembly 750 as described above.

The method may further comprising verifying the detector based on the response signal. For example, the verifying comprises comparing one or more parameters of the response signal with a specification for the one or more parameters. Verification of the detector is when the one or more parameters of the response signal, is at least equal to the specification. Thus, it may be determined that the detector is functioning as intended when the parameters meet the specification parameters.

The method of interrogating at least part of the detector may be carried out at various different times. For example, the interrogating may be carried out prior to the detector being positioned in an assessment apparatus. Alternatively, the interrogating may be carried out during fabrication when the detector is positioned in an assessment apparatus. Alternatively, the interrogating may be carried out as maintenance of the assessment apparatus, i.e. when the assessment apparatus has been assembled, and possible used for assessing samples.

In the present description, it will be understood that the charged particles/signal particles are generally intended to be electrons, or other negatively charged particles. However, contrary to the above, the charged particles/signal particles may be positively charged particles, e.g. ions. Thus, a primary ion beam may be provided. With a primary ion beam, secondary ions could be emitted from the sample that could be detected by the charge based type detector. However, this would also generate negative charged particles, e.g. secondary electrons at the same time. So the charge accumulated with this charge based type detector will be a mix of positively and negatively charged particles, which would make the charged measurement unreliable. However, having either a positive or negative bias on the charge based type detector would make it possible to choose one of the charge polarities. Because of the much smaller range of ions than electrons in a material, backscatter ions need a much larger kinetic energy to be able to reach any further detectors, e.g. the scintillator and/or semiconductor type detector. Thus, not all backscatter ions will make it to this detector component. To improve the detection of backscatter ions, the charge based type detector could be made thinner. In the instance that ions are used instead of negatively charged particles, then any bias referred to above would be opposite, e.g. a positive bias should be used instead of a negative one and vice versa.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons. The charged-particle optical device may be a negative charged particle device. The charged-particle optical device may otherwise be referred to as an electron-optical device. It will be understood that an electron is a specific charged particle and can replace all instances of charged particle referred to throughout the application as appropriate. For example, the source may specifically provide electrons. The charged particle referred to throughout the specification may be specifically a negatively charged particle.

The charged particle-optical device may more specifically be defined as a charged particle-optical column. In other words, the device may be provided as a column. The column may thus comprise an objective lens array assembly as described above. The column may thus comprise a charged particle optical system as described above, for example comprising an objective lens array and optionally a detector array and/or optionally a condenser lens array.

The charged particle optical device described above comprises at least the objective lens array 240. The charged particle optical device may comprise the detector array 241 and/or detector assembly. The charged particle optical device may comprise the control lens array 250. The charged particle optical device comprising the objective lens array and the detector array may thus be interchangeable with, and referred to as, the objective lens array assembly, which may optionally comprise the control lens array 250. The charged particle optical device may comprise additional components, e.g. as described in relation to **FIG. 3****.** Thus, the charged particle optical device may be interchangeable with, and referred to as, a charged particle assessment tool 40 and/or an charged particle optical system if comprising the additional components in these figures.

References to up and low, upper and lower, lowest, up and down, above and below should be understood as referring to directions parallel to the (typically but not always vertical) upbeam and downbeam directions of the electron beam or multi-beam impinging on the sample 208. Thus, references to up beam and down beam are intended to refer to directions in respect of the beam path independently of any present gravitational field.

References to elements being aligned along a beam path or sub-beam path are understood to mean that the respective elements are positioned along the beam path or sub-beam path.

An assessment tool according to an embodiment of the invention may be a tool which makes a qualitative assessment of a sample (e.g. pass/fail), one which makes a quantitative measurement (e.g. the size of a feature) of a sample or one which generates an image of map of a sample. Thus, the assessment tool could be any appropriate device, apparatus or system used for assessment. For example, the assessment tool could be any of the charged particle-optical device, e.g. as part of charged particle beam apparatus 100, or more specifically the charged particle-optical device 40, and/or as part of an optical lens array assembly, when used for assessment. Examples of assessment tools are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The charged particle beam tool 40 (which may be a charged particle -optical column) may be a component of an assessment tool; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 241, the condenser lens 231, correctors, collimator element array 271 and scan deflector array 260, under the control of the controller or control system or control unit. An actuatable component, such as a stage, may be controllable to actuate and thus move relative to another components such as the beam path using one or more controllers, control systems, or control units to control the actuation of the component.

The embodiments herein described comprising a detector assembly may take the form of a series of aperture arrays or charged particle-optical elements arranged in arrays along a beam or a multi-beam path. Such charged particle-optical elements may be electrostatic. In an embodiment all the charged particle-optical elements, for example from a beam limiting aperture array to a last charged particle-optical element in a sub-beam path before a sample, may be electrostatic and/or may be in the form of an aperture array or a plate array. In some arrangements one or more of the charged particle-optical elements are manufactured as a microelectromechanical system (MEMS) (i.e. using MEMS manufacturing techniques).

The system or device of such architectures as depicted in at least **FIG. 3** and as described above may comprise components such as an upper beam limiter, a collimator element array 271, a control lens array 250, a scan deflector array 260, an objective lens array 241, a beam shaping limiter and/or a detector array 241 and/or detector assembly; one or more of these elements that are present may be connected to one more adjacent elements with an isolating element such as a ceramic or glass spacer.

Any element or collection of elements may be replaceable or field replaceable within the charged particle beam tool 40. The one or more charged particle-optical components in the charged particle beam tool 40, especially those that operate on sub-beams or generate sub-beams, such as aperture arrays and manipulator arrays may comprise one or more MEMS.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses. Clause 1. A detector inspection device for interrogating at least part of a detector comprised in a charged particle-optical assessment apparatus, the detector inspection device comprising: a coupler configured to be positioned proximate to a detector element of a detector; and a device controller configured to apply a stimulating signal to the coupler to stimulate a response signal in the detector for interrogating at least part of the detector.

Clause 2. The detector inspection device of clause 1, wherein the coupler comprises a facing surface configured to face the detector element.

Clause 3. The detector inspection device of clause 2, wherein the coupler, or at least the facing surface of the coupler, is shaped to match at least a portion of the detector element, desirably the whole detector element.

Clause 4. The detector inspection device of clause 2, wherein the detector comprises an array of detector elements, desirably wherein the coupler, or at least the facing surface of the coupler, is shaped to match at least a portion of one of the detector elements, or multiple detector elements of the detector element array.

Clause 5. The detector inspection device of any clause 4, wherein the detector inspection device is configured to stimulate one detector element at a time.

Clause 6. The detector inspection device of clause 4, wherein the detector elements are selectively simultaneously stimulated.

Clause 7. The detector inspection device of any one of the preceding clauses, wherein the coupler surrounds, or is laterally positioned relative to, the detector element.

Clause 8. The detector inspection device of any one of the preceding clauses, wherein the coupler may be a lens electrode of a charged particle-optical assessment apparatus.

Clause 9. The detector inspection device of any one of the preceding clauses, wherein the detector inspection device is configured to be removably insertable into a charged particle-optical assessment apparatus.

Clause 10. The detector inspection device of any one of the preceding clauses, wherein the device controller is configured to control potentials applied to the detector element.

Clause 11. The detector inspection device of any one of the preceding clauses, wherein the detector further comprises circuitry configured to verify the detector, wherein the circuitry is configured to verify the detector based on the response signal, desirably the circuitry comprises detector circuitry associated which each detector element, desirably verification of the detector comprises verifying the detector circuitry, desirably the circuitry comprises verification circuitry configured to verify the detector element.

Clause 12. The detector inspection device of any of the preceding clauses, wherein the device controller is configured to verify the detector based on the response signal, wherein the device controller is configured to verify the detector by comparing one or more parameters of the response signal with a specification for the one or more parameters such that the one or more parameters is at least equal to the specification.

Clause 13. The detector inspection device of any one of the preceding clauses, wherein the stimulating signal has a varying current, desirably an alternating current and/or the stimulating signal has a varying voltage, desirably an alternating voltage.

Clause 14. A detector assembly for an assessment apparatus for projecting a charged particle beam towards a sample, the assembly comprising: a detector comprising a detector element configured to detect signals from a sample and a shield electrode positioned proximate to the detector element; and a detector controller configured to apply a stimulating signal to at least part of the shield electrode to stimulate a response signal in the detector for interrogating at least part of the detector.

Clause 15. The detector assembly of clause 14, wherein the detector element is a conductive portion configured to be exposed to the shield electrode, desirably wherein the detector element is a charge based detector element, desirably wherein the detector comprises one or more detector types.

Clause 16. A detector assembly for a multi-beam assessment apparatus for projecting a charged particle beam towards a sample, the assembly comprising: a detector comprising: a detector element comprising a semiconductor type element and/or a converter type element; and a verification element associated with the detector element; and a coupler configured to be positioned proximate to the detector element; and a detector controller configured to apply a stimulating signal to at least part of the coupler to stimulate a response signal in the detector for interrogating at least part of the detector.

Clause 17. The detector assembly of clause 16, wherein the verification element comprises a conductive portion configured to be exposed to the coupler, desirably the conductive portion is in electrical communication with circuitry.

Clause 18. The detector assembly of either of clauses 16 or 17, wherein the coupler comprises a shield electrode.

Clause 19. The detector assembly of any one of clauses 14-18, wherein the detector comprises a detector substrate comprising the detector element and the shield element.

Clause 20. The detector assembly of clause 19, wherein the detector substrate further comprises the detector controller.

Clause 21. The detector assembly of any one of clauses 14-20, wherein the detector controller is configured to control potentials applied to the detector, and desirably to the detector element and/or the shield electrode.

Clause 22. The detector assembly of any one of clauses 14-21, wherein the detector assembly has an operational state in which the detector element detects signals from the sample and an interrogation state in which the detector element is interrogated, wherein in the interrogation state, the stimulating signal is applied to at least part of the shield electrode so as to stimulate the response signal in the detector.

Clause 23. The detector assembly of any one of clauses 14-22, wherein the shield electrode comprises a shield element array, desirably wherein the detector controller is configured to apply the stimulating signal to individual shield elements, or to multiple shield elements, or to all shield elements.

Clause 24. The detector assembly of any one of clauses 14-23, wherein the shield electrode surrounds, or is laterally positioned relative to, at least part of the detector element.

Clause 25. The detector assembly of any one of clauses 14-24, wherein the stimulating signal is applied to the whole shield electrode, desirably around the detector element.

Clause 26. The detector assembly of any one of clauses 14-25, wherein the detector comprises a plurality of detector elements, desirably wherein the shield electrode is interposed between adjoining detector elements.

Clause 27. The detector assembly of clause 26, wherein the detector assembly is configured to stimulate one detector element at a time.

Clause 28. The detector assembly of clause 26, wherein the detector elements are selectively simultaneously stimulated.

Clause 29.The detector assembly of any one of clauses 14-28, wherein a portion of the shield electrode is substantially parallel and adjacent to the detector element, desirably a surface of the portion of the shield is coplanar with a surface of the detector element and/or a surface of the portion of the shield is further from a major surface of the detector substrate than the surface of the substrate, desirably at least part of the detector element interposes between one of the portions of the shield and the sample position.

Clause 30. The detector assembly of any one of clauses 14-29, further comprising circuitry configured to verify the detector, wherein the circuitry is configured to verify the detector based on the response signal, desirably the circuitry comprises detector circuitry associated which each detector element, desirably verification of the detector comprises verifying the detector circuitry, desirably the circuitry comprises verification circuitry configured to verify the detector element, desirably the verification circuitry comprises part of the detector controller.

Clause 31. The detector assembly of any one of clauses 14-30, wherein the detector controller is configured to verify the detector based on the response signal, wherein the detector controller is configured to verify the detector by comparing one or more parameters of the response signal with a specification for the one or more parameters such that the one or more parameters is at least equal to the specification.

Clause 32. The detector assembly of any one of clauses 14-31, wherein the stimulating signal has a varying current, desirably an alternating current.

Clause 33. A detector array comprising multiple detector assemblies of any one of clauses 14-32, wherein two or more of the detector assemblies are located at different distances relative to a position of a sample and/or two or more of the detector assembles are located at a similar distance from the position of the sample.

Clause 34. A detector array comprising a detector assembly of any one of clauses 14-32, wherein the detector comprises an array of detector elements, and desirably the shield electrode comprises a shield element array.

Clause 35. An assessment apparatus for assessing a sample, the assessment apparatus comprising the detector assembly of any one of clauses 14-32, or the detector array of any one of clauses 33-34.

Clause 36. An assessment apparatus for assessing a sample, desirably for projecting charged particles towards a sample desirably in an array of beams, the assessment apparatus comprising: a sample support for supporting a sample; a detector assembly comprising a detector configured to detect signals from a sample supported by the sample support; and a detector controller configured to control and be in communication with the detector; and the detector inspection device of any of clauses 1 to 13, wherein the device controller of the detector inspection device is configured to be in signal communication with the detector controller.

Clause 37. The assessment apparatus of either of clauses 35 or 36, wherein the detector assembly is positioned such that the detector element is facing the sample.

Clause 38. The assessment apparatus of any one of clauses 35-37, wherein the detector assembly is associated with charged particle-optical components of a charged particle-optical device of the assessment apparatus, desirably incorporated in the one or more charged particle-optical components, desirably wherein the detector assembly is associated with an objective lens, desirably incorporated into the objective lens.

Clause 39. The assessment apparatus of any one of clauses 34-38 , wherein the charged particle-optical device is a primary charged particle-optical device and the detector assembly is associated with charged particle-optical components of a secondary device of the assessment apparatus.

Clause 40. A method of interrogating at least part of a detector for a charged particle-optical assessment apparatus, the method comprising: generating a stimulating signal in a coupler; stimulating a response signal in the detector element in response to the stimulating signal; and detecting the response signal in the detector element.

Clause 41. The method of clause 40, further comprising verifying the detector based on the response signal.

Clause 42. The method of clause 40 or 41, wherein the verifying comprises comparing one or more parameters of the response signal with a specification for the one or more parameters.

Clause 43. The method of clause 42, wherein verification of the detector is when the one or more parameters of the response signal, is at least equal to the specification.

Clause 44. The method of any one of clauses 40-43, wherein the method uses the detector inspection device of any one of clauses 1-13, or the detector assembly of any one of clauses 14-32, or the detector array of any one of clauses 33-34, or the assessment apparatus of any of clauses 35-39.

Clause 45. The method of any one of clauses 40-44, further comprising applying a varying current, desirably, an alternating current to the coupler.

Clause 46. The method of any one of clauses 40-45, wherein the method of interrogating at least part of the detector is carried out prior to the detector being positioned in an assessment apparatus, or is carried out during fabrication when the detector is positioned in an assessment apparatus, or is carried out as maintenance of the assessment apparatus.

## Claims

1. A detector inspection device for interrogating at least part of a detector comprised in a charged particle-optical assessment apparatus, the detector inspection device comprising:
a coupler configured to be positioned proximate to a detector element of a detector; and
a device controller configured to apply a stimulating signal to the coupler to stimulate a response signal in the detector for interrogating at least part of the detector.

2. The detector inspection device of claim 1, wherein the coupler comprises a facing surface configured to face the detector element.

3. The detector inspection device of claim 2, wherein the coupler, or at least the facing surface of the coupler, is shaped to match at least a portion of the detector element, desirably the whole detector element.

4. The detector inspection device of claim 2, wherein the detector comprises an array of detector elements, desirably wherein the coupler, or at least the facing surface of the coupler, is shaped to match at least a portion of one of the detector elements, or multiple detector elements of the detector element array.

5. The detector inspection device of any claim 4, wherein the detector inspection device is configured to stimulate one detector element at a time.

6. The detector inspection device of claim 4, wherein the detector elements are selectively simultaneously stimulated.

7. The detector inspection device of any one of the preceding claims, wherein the coupler surrounds, or is laterally positioned relative to, the detector element.

8. The detector inspection device of any one of the preceding claims, wherein the coupler may be a lens electrode of a charged particle-optical assessment apparatus.

9. The detector inspection device of any one of the preceding claims, wherein the detector inspection device is configured to be removably insertable into a charged particle-optical assessment apparatus.

10. The detector inspection device of any one of the preceding claims, wherein the device controller is configured to control potentials applied to the detector element.

11. The detector inspection device of any one of the preceding claims, wherein the detector further comprises circuitry configured to verify the detector, wherein the circuitry is configured to verify the detector based on the response signal, desirably the circuitry comprises detector circuitry associated which each detector element, desirably verification of the detector comprises verifying the detector circuitry, desirably the circuitry comprises verification circuitry configured to verify the detector element.

12. The detector inspection device of any of the preceding claims, wherein the device controller is configured to verify the detector based on the response signal, wherein the device controller is configured to verify the detector by comparing one or more parameters of the response signal with a specification for the one or more parameters such that the one or more parameters is at least equal to the specification.

13. The detector inspection device of any one of the preceding claims, wherein the stimulating signal has a varying current, desirably an alternating current and/or the stimulating signal has a varying voltage, desirably an alternating voltage.

14. An assessment apparatus for assessing a sample, desirably for projecting charged particles towards a sample desirably in an array of beams, the assessment apparatus comprising:
a sample support for supporting a sample;
a detector assembly comprising a detector configured to detect signals from a sample supported by the sample support; and a detector controller configured to control and be in communication with the detector; and
the detector inspection device of any of claims 1 to 13, wherein the device controller of the detector inspection device is configured to be in signal communication with the detector controller.

15. A method of interrogating at least part of a detector for a charged particle-optical assessment apparatus, the method comprising:
generating a stimulating signal in a coupler;
stimulating a response signal in the detector element in response to the stimulating signal; and
detecting the response signal in the detector element.
